# EUROPEAN PATENT APPLICATION

(11) **EP 4 753 431 A1**
(43) Date of publication of application: **03.06.2026**
(21) Application number: 25217910.6
(22) Date of filing: 24.11.2025
(51) Int. Cl.: H10K 71/16, H10K 59/35, C23C 14/04

(54) **APPARATUS AND METHOD FOR MANUFACTURING A DISPLAY PANEL, AND ELECTRONIC APPARATUS INCLUDING THE DISPLAY PANEL**

(30) Priority: 27.11.2024 KR 20240172771
(71) Applicant: Samsung Display Co., Ltd., Yongin-si, Gyeonggi-do 17113 (KR)
(72) Inventor: Lee, Sangshin, 17113 Yongin-si, Gyeonggi-do (KR); Kang, Yeonju, 17113 Yongin-si, Gyeonggi-do (KR); Lee, Yuri, 17113 Yongin-si, Gyeonggi-do (KR)
(74) Representative: Gulde & Partner

(57) **Abstract**

An apparatus (20) for manufacturing a display panel (11), a method for manufacturing the display panel (11), and an electronic device (10) including the display panel (11) are provided. The apparatus (20) may include a deposition source (24) and a deposition mask (25) including a plurality of openings (254OP) corresponding to a plurality of emission areas (EA) of a display panel (11), and at least some of the plurality of openings (254OP) in the deposition mask (25) may have a second shape (SH2) corresponding to a first shape (SH1) obtained by overlapping the plurality of emission areas (EA) with one another.

## Description

### BACKGROUND

### 1. Field

One or more embodiments relate to an apparatus and method for manufacturing a display panel, and an electronic apparatus including the display panel.

### 2. Description of the Related Art

A display panel may provide an image through a plurality of pixels. The pixels may include a light-emitting diodes (LEDs) with an emission layer. The pixels of the display panel may be implemented by arranging one or more suitable layers, including the emission layer, on a substrate. These layers (for example, the emission layer) may be formed as a deposition pattern by depositing a deposition material on the substrate. To create this deposition pattern (for these suitable layers on the substrate, e.g., to implement the deposition pattern), a deposition mask may be utilized.

The deposition mask may be arranged to face one surface of the substrate, and the deposition material may be sprayed toward the deposition mask and the substrate. The deposition material may pass through an opening provided in the deposition mask and may be deposited on the substrate, forming a pattern that may match the shape of the opening in the deposition mask (the mask's opening). The deposited material pattern (e.g., the deposition material deposited on the substrate and having the shape of the opening in the deposition mask) may be referred to as the deposition pattern.

### SUMMARY

Aspects of one or more embodiments of the present disclosure are directed toward an apparatus for manufacturing a display panel including a plurality of emission areas. For example, an area (e.g., an emission area) in which a light-emitting diode of the display panel is to emit light, may be provided to have one or more suitable shapes. To implement such one or more suitable shapes of emission areas, the emission layers having one or more suitable shapes may be arranged on a substrate. To arrange emission layers of one or more suitable shapes, a deposition mask may be desired or required to have one or more suitable shapes of openings. Implementing openings of different shapes in the deposition mask may reduce production efficiency of the deposition mask and/or accuracy of a deposition process.

For example, aspects of one or more embodiments may focus on an apparatus for manufacturing a display panel with multiple emission areas. These areas, where light-emitting diodes emit light, may have various shapes. To achieve these shapes, emission layers may be arranged on a substrate utilizing a deposition mask with openings of different shapes. However, having openings of different shapes in the deposition mask may reduce production efficiency and accuracy in the deposition process.

Additional aspects one or more embodiments of the present will be set forth in part in the description which follows and, in part, will be apparent from the description, or may be learned by practice of the presented embodiments of the disclosure.

According to one or more embodiments, an apparatus includes a deposition source, and a deposition mask including a plurality of openings corresponding to a plurality of emission areas of a display panel, where at least some of the plurality of openings in the deposition mask have a second shape corresponding to a first shape obtained by overlapping the plurality of emission areas with one another. The apparatus is an apparatus for manufacturing the display panel.

In one or more embodiments, the first shape may be obtained by connecting at least some of outermost portions of the plurality of emission areas that overlap one another.

In one or more embodiments, a shape of at least one emission area among the plurality of emission areas may be different from a shape of another emission area among the plurality of emission areas.

In one or more embodiments, the first shape may be obtained by aligning centers of the plurality of emission areas and overlapping the plurality of emission areas.

In one or more embodiments, shapes of the plurality of openings in the deposition mask may be the same as one another.

In one or more embodiments, a size of the second shape may be greater than a size of the first shape.

In one or more embodiments, the first shape and the second shape may be geometrically the same, and dimensions of the second shape may be larger than dimensions of the first shape.

In one or more embodiments, in plan view, an edge of each of the plurality of openings in (e.g., of) the deposition mask may be spaced and/or apart (e.g., spaced apart or separated) from an outline of each of the plurality of emission areas.

In one or more embodiments, the plurality of emission areas may include elliptical areas having major axes extending in different directions from one another (e.g., the plurality of emission areas may include elliptical areas, each having major axes may extend in different directions from one another).

According to one or more embodiments, a method includes arranging, on a substrate, a pixel-defining layer including a plurality of emission areas, arranging, on the pixel-defining layer, a deposition mask including (with) a plurality of openings corresponding to the plurality of emission areas, and spraying a deposition material toward the deposition mask and the pixel-defining layer, where at least some of the plurality of openings in (e.g., of) the deposition mask have a second shape corresponding to a first shape obtained by overlapping the plurality of emission areas. The method is a method for manufacturing a display panel.

In one or more embodiments, the first shape may be obtained by connecting at least some of outermost portions of the plurality of emission areas that overlap one another.

In one or more embodiments, a shape of at least one emission area among the plurality of emission areas may be different from a shape of another emission area among the plurality of emission areas.

In one or more embodiments, the first shape may be obtained by aligning centers of the plurality of emission areas and overlapping the plurality of emission areas.

In one or more embodiments, shapes of the plurality of openings in the deposition mask may be the same as one another.

In one or more embodiments, a size of the second shape may be greater than a size of the first shape.

In one or more embodiments, the first shape and the second shape may be geometrically the same, and dimensions of the second shape may be larger than dimensions of the first shape.

In one or more embodiments, the pixel-defining layer may include a plurality of holes defining the plurality of emission areas, and if (e.g., when) viewed in a direction in which the deposition material is sprayed, an edge of each of the plurality of openings in the deposition mask may be spaced and/or apart (e.g., spaced apart or separated) from an edge of each of the plurality of holes in the pixel-defining layer.

In one or more embodiments, the plurality of emission areas may include elliptical areas having major axes extending in different directions from one another (e.g., the plurality of emission areas may include elliptical areas, each having major axes may extend in different directions from one another).

According to one or more embodiments, a display panel include a substrate, a plurality of pixel electrodes arranged on the substrate, a pixel-defining layer arranged on the plurality of pixel electrodes and including a plurality of holes defining a plurality of emission areas, and an intermediate layer overlapping the plurality of holes, arranged on the pixel-defining layer, and including a plurality of deposition patterns, each of the plurality of deposition patterns having a portion arranged within a corresponding hole among the plurality of holes, and an opposite electrode arranged on the intermediate layer, wherein, in plan view, at least some of the plurality of deposition patterns may have a second shape corresponding to a first shape obtained by overlapping the plurality of holes.

In one or more embodiments, a shape of at least one hole among the plurality of holes may be different from a shape of another hole among the plurality of holes.

In one or more embodiments, the first shape may be obtained by aligning centers of the plurality of holes and overlapping the plurality of holes.

In one or more embodiments, a size of the second shape may be greater than a size of the first shape.

In one or more embodiments, the first shape and the second shape may be geometrically the same, and dimensions of the second shape may be larger than dimensions of the first shape.

In one or more embodiments, one deposition pattern among the plurality of deposition patterns may have a first portion at (e.g., arranged in) the corresponding hole in the pixel-defining layer and may have a second portion on (e.g., arranged on) a top surface of the pixel-defining layer.

In one or more embodiments, the first portion of the deposition pattern may be connected to the second portion of the deposition pattern.

According to one or more embodiments, an electronic apparatus (e.g., device) includes a display panel including a plurality of emission areas, where the display panel includes a substrate, a plurality of pixel electrodes arranged on the substrate, a pixel-defining layer arranged on the plurality of pixel electrodes and including a plurality of holes defining the plurality of emission areas, an intermediate layer overlapping the plurality of holes, arranged on the pixel-defining layer, and including a plurality of deposition patterns, each of the plurality of deposition patterns having a portion arranged within a corresponding hole among the plurality of holes, and an opposite electrode arranged on the intermediate layer, where, in plan view, at least some of the plurality of deposition patterns have a second shape corresponding to a first shape obtained by overlapping the plurality of holes.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram of an electronic apparatus according to one or more embodiments;
FIGS. 2, 3, and 4 are schematic views each showing electronic apparatuses according to one or more embodiments;
FIG. 5 is a schematic plan view of a display panel according to one or more embodiments;
FIGS. 6A, 6B, and 6C are each an equivalent circuit diagram of a pixel of a display panel according to one or more embodiments;
FIG. 7 is a cross-sectional view of a display panel according to one or more embodiments;
FIG. 8A is a plan view showing a portion of a display panel according to one or more embodiments;
FIG. 8B is a plan view showing a portion of a display panel according to one or more embodiments;
FIG. 9A is a plan view showing a portion of a display panel according to one or more embodiments;
FIG. 9B is a plan view showing a portion of a display panel according to one or more embodiments;
FIG. 10A is a plan view showing a portion of a display panel according to one or more embodiments;
FIG. 10B is a plan view showing a portion of a display panel according to one or more embodiments;
FIG. 11A is a plan view showing a portion of a display panel according to one or more embodiments;
FIG. 11B is a plan view showing a portion of a display panel according to one or more embodiments;
FIG. 12 is a cross-sectional view showing a display panel manufacturing apparatus according to one or more embodiments;
FIG. 13 is an exploded perspective view showing a deposition mask according to one or more embodiments;
FIG. 14A is a schematic view of emission areas according to one or more embodiments;
FIGS. 14B, 14C, and 14D are schematic views each showing a first shape and a second shape according to one or more embodiments;
FIGS. 15B, 15C, and 15D are schematic views each showing a first shape and a second shape according to one or more embodiments; and
FIGS. 16B, 16C, and 16D are schematic views each showing a first shape and a second shape according to one or more embodiments.

### DETAILED DESCRIPTION

Reference will now be made in more detail to one or more embodiments, examples of which are illustrated in the accompanying drawings, wherein like reference numerals refer to like elements throughout, and duplicative descriptions thereof may not be provided the specification. In this regard, the present embodiments may have different forms and should not be construed as being limited to the descriptions set forth herein. Accordingly, one or more embodiments are merely described in more detail , by referring to the drawings, to explain aspects of the present description.

Unless otherwise noted, like reference numerals, characters, or combinations thereof denote like elements throughout the attached drawings and the written description, and thus, descriptions thereof will not be repeated. Further, parts not related to the description of one or more embodiments might not be shown to make the description clear.

In the drawings, the relative sizes of elements, layers, and regions may be exaggerated for clarity. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

One or more suitable embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the present disclosure. Thus, embodiments disclosed herein should not be construed as limited to the particular illustrated shapes of regions, but are to include deviations in shapes that result from, for instance, manufacturing.

For example, an implanted region illustrated as a rectangle may have rounded or curved shapes and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting. Additionally, as those skilled in the art would realize, the described embodiments may be modified in one or more suitable different ways, all without departing from the scope of the present disclosure as defined by the appended claims and equivalents thereof.

In the detailed description, for the purposes of explanation, numerous specific details are set forth to provide a thorough understanding of one or more suitable embodiments. It is apparent, however, that one or more suitable embodiments may be practiced without these specific details or with one or more equivalent arrangements. In other instances, well-known structures and devices are shown in block diagram form to avoid unnecessarily obscuring one or more suitable embodiments.

Spatially relative terms, such as "beneath," "below," "lower," "under," "above," "upper," and the like, may be utilized herein for ease of explanation to describe one element's relationship to another element(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements would then be oriented "above" the other elements. Thus, the example terms "below" and "under" can encompass both an orientation of above and below. The device may be otherwise oriented (e.g., rotated 90 degrees or at other orientations) and the spatially relative descriptors utilized herein should be interpreted accordingly. Similarly, if (e.g., when) a first part is described as being arranged "on" a second part, this indicates that the first part is arranged at an upper side or a lower side of the second part without the limitation to the upper side thereof on the basis of the gravity direction.

Further, in this specification, the phrase "on a plane," or "in plan view," means viewing a target portion from the top, and the phrase "on a cross-section" means viewing a cross-section formed by vertically cutting a target portion from the side.

For the purposes of the present disclosure, expressions such as "at least one of," "one of," and "selected from," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, XZ, YZ, and ZZ, or any variation thereof. Similarly, the expression such as "at least one of A and/or B" may include A, B, or A and B. As utilized herein, the term "and/or" includes any and all combinations of one or more of the associated listed items. For example, the expression such as "A and/or B" may include A, B, or A and B. In addition, the expression "at least one of A and B" represents A, B, or A and B.

Further, the use of "may" when describing embodiments of the present disclosure refers to "one or more embodiments of the present disclosure".

The same reference numerals refer to the same components. Further, in the drawings, the thickness, the ratio, and the dimension of components are exaggerated for effective description of technical contents. The expression "and/or" includes one or more combinations which associated components are capable of defining.

One or more suitable modifications may be applied to the present embodiments, and particular embodiments will be illustrated in the drawings and described in the detailed description section. The effect and features of the disclosure, and a method to achieve the same, will be clearer referring to the detailed descriptions with the drawings. However, the present embodiments may be implemented in one or more suitable forms, not by being limited to one or more embodiments presented.

Hereinafter, one or more embodiments of the present disclosure will be described in more detail with reference to the accompanying drawings, and in the description with reference to the drawings, the same or corresponding components are indicated by the same reference numerals and redundant descriptions thereof are not provided.

In the following embodiment, it will be understood that if (e.g., when) a component such as a layer, film, area, or plate is referred to as being "formed on" another layer, film, area, or plate, it can be directly or indirectly formed on the other layer, film, area, or plate. For example, for example, intervening layers, films, areas, or plates may be present. In addition, sizes of components in the drawings may be exaggerated or reduced for convenience of explanation. For example, because sizes and thicknesses of components in the drawings are arbitrarily illustrated for convenience of explanation, the following embodiments are not limited thereto.
It will be understood that, although the terms "first", "second", etc. may be utilized herein to describe one or more suitable components, the components should not be limited by the terms. The terms are only utilized to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

The terminology utilized herein is for the purpose of describing particular embodiments only and is not intended to be limiting of the present disclosure. As utilized herein, the singular forms "a" and "an" are intended to include the plural forms as well, unless the context clearly indicates otherwise.

In the following embodiment, the expression "x direction" may refer to both (e.g., simultaneously) a +x direction and a -x direction, that is, a ±x direction. In the following embodiment, the expression "y direction" may refer to both (e.g., simultaneously) a +y direction and a -y direction, that is, a ±y direction. In the following embodiment, the expression "z direction" may refer to both (e.g., simultaneously) a +z direction and a -z direction, that is, a ±z direction. In the following embodiments, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

In the present disclosure, it will be understood that the terms "include/includes/including," "comprise/comprises/comprising," or "have/has/having," specifies the presence of stated features, integers, numbers, steps, operations, elements, and/or components, but do not preclude the presence or addition of one or more other features, integers, numbers, steps, operations, elements, components, and/or groups thereof. Additionally, the terms "include/includes/including," "comprise/comprises/comprising," or "have/has/having," or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As utilized herein, the term "substantially," "about," "approximately," and similar terms are utilized as terms of approximation and not as terms of degree, and are intended to account for the inherent deviations in measured or calculated values that would be recognized by those of ordinary skill in the art. "About" or "approximately," as utilized herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. When one or more embodiments may be implemented differently, a specific process order may be performed differently from the described order. For example, two consecutively described processes may be performed substantially at the same time or performed in an order opposite to the described order.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, for example, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

Unless otherwise defined, all terms (including technical terms and scientific terms) utilized in the specification have the same meaning as commonly understood by those skilled in the art to which the present disclosure belongs. Further, terms such as terms defined in the dictionaries commonly utilized should be interpreted as having a meaning consistent with the meaning in the context of the related technology and should not be interpreted in overly ideal or overly formal meanings unless explicitly defined herein.

It will be understood that if (e.g., when) a component (e.g., an element, an area, a layer, a part, a portion, a region, and/or the like) is referred to as being "on", "formed on", "disposed on", "connected to", "connected with", or "coupled to" another component, this refers to that the component may be directly or indirectly on, formed on, disposed on, connected to, connected with, or coupled to the other component, such that one or more intervening components may be present therebetween. For example, when an element, layer, part, portion, region, or component is referred to as being "electrically connected" or "electrically coupled" to another element, layer, part, portion, region, or component, it can be directly electrically connected or coupled to the other element, layer, part, portion, region, or component, or intervening elements, layers, parts, portions, regions, or components may be present. However, "directly connected/directly coupled" refers to one component directly connecting or coupling another component without any intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

A display panel/apparatus according to one or more embodiments may be applied to one or more suitable electronic apparatuses/devices. For example, an electronic apparatus according to one or more embodiments may include a display apparatus and may further include a module or a device, each having an additional function, in addition to the display apparatus. The display apparatus according to one or more embodiments may include a display panel.

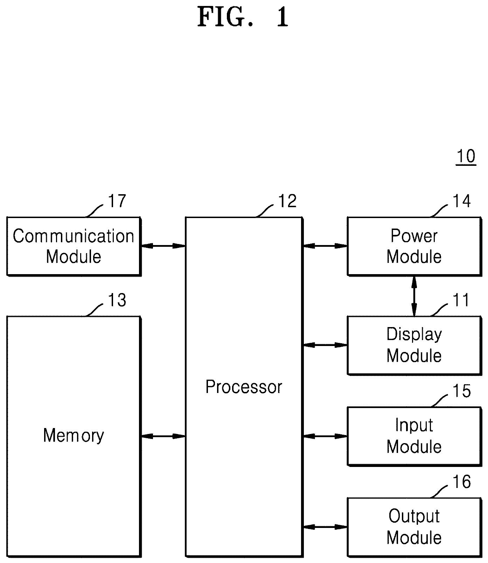

FIG. 1 is a block diagram of an electronic apparatus according to one or more embodiments. Referring to FIG. 1, an electronic apparatus 10 may include a display panel 11, a processor 12, a memory 13, and a power module 14.

The processor 12 may include at least one of a central processing unit (CPU), an application processor (AP), a graphic processing unit (GPU), a communication processor (CP), an image signal processor (ISP), and/or a controller. In one or more embodiments, the processor 12 may be divided and provided into two or more parts from a functional or structural perspective. For example, the processor 12 may include a main processor in the form of a first driving chip that includes a CPU, and an auxiliary processor in the form of a second driving chip that includes a controller to receive an image signal from the main processor and process the image signal to match interface specifications of the display panel 11.

The memory 13 may include at least one of non-volatile memory and/or volatile memory. The memory 13 may store data information necessary for the operation of the processor 12 or the display panel 11. If (e.g., when) the processor 12 executes an application stored in the memory 13, an image data signal, and/or an input control signal may be transmitted to the display panel 11, and the display panel 11 may process the received signal and output image information through a display screen.

The power module 14 may include a power supply module such as a power adapter or a battery apparatus, and a power conversion module that converts power supplied by the power supply module and generates power necessary for the operation of the electronic apparatus 10. The power conversion by the power conversion module may include, but is not limited to, DC-DC conversion, AC-DC conversion, and/or DC-AC conversion.

The electronic apparatus 10 may further include an input module 15, a non-image output module 16, and/or a communication module 17.

The input module 15 may provide input information to the processor 12 and/or the display panel 11. The input module 15 may include a physical button, a keyboard, a microphone, and/or one or more suitable sensor modules. Examples of the sensor modules may include a touch sensor, a pressure sensor, a distance sensor, a position sensor, a digitizer, a motion recognition sensor, a camera sensor, a light-receiving sensor, a photoelectric conversion sensor, a temperature sensor, and/or a biometric sensor such as a blood pressure sensor, a blood glucose sensor, an electrocardiogram sensor, and/or a heart rate sensor.

The non-image output module 16 may receive information other than an image received from the processor 12 and provide the information to a user. Examples of the non-image output module 16 may include an audio module, a haptic module, and/or a light-emitting module, and may include other functional modules (for example, a cooling module of a refrigerator) that are unique to the electronic apparatus 10.

The communication module 17 is responsible for transmission and reception of information between the electronic apparatus 10 and an external apparatus, and may include a receiver and a transmitter. The communication module 17 may include one or more suitable wireless communication modules such as a mobile communication module, a Wi-Fi module, and a Bluetooth module, and/or one or more suitable wired communication modules.

In one or more embodiments, at least one of the components of the electronic apparatus 10 may be included in the display apparatus. In addition, some of individual modules included in one module may be functionally included in the display apparatus, whereas some others (e.g., other individual modules that are not included in the display apparatus) may be provided separately from the display apparatus. For example, the display apparatus may include the display panel 11, whereas the processor 12, the memory 13, and the power module 14 may be provided in the form of components within the electronic apparatus 10, rather than within the display apparatus. In some embodiments, the power module 14 may be provided within the display apparatus and may supply power to the processor 12 and the memory 13, which are provided within the electronic apparatus 10, rather than within the display apparatus, and the disclosure is not limited to these examples.

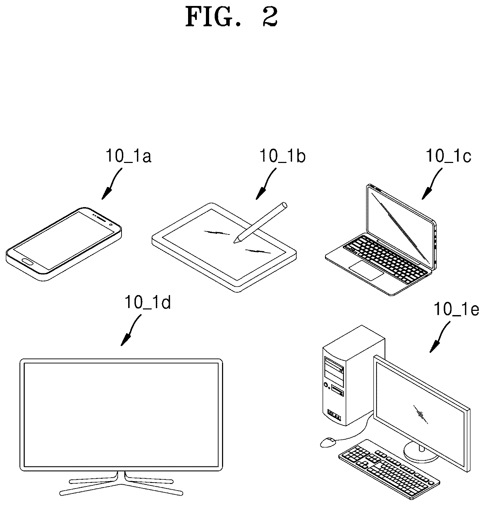

FIGS. 2 to 4 are schematic views each showing electronic apparatuses according to one or more embodiments. FIGS. 2 to 4 each shows examples of one or more suitable electronic apparatuses to which a display apparatus according to one or more embodiments is applied.

FIG. 2 shows, as examples of an electronic apparatus, a smartphone 10_1a, a tablet PC 10_1b, a laptop 10_1c, a TV 10_1d, and a desk monitor 10_1e.

The smartphone 10_1a may include an input module, such as a touch sensor, and/or a communication module, in addition to a display panel. The smartphone 10_1a may process information received through the communication module or other input module and display the information through the display panel of a display apparatus.

Similar to the smartphone 10_1a, the tablet PC 10_1b, the laptop 10_1c, the TV 10_1d, and the desk monitor 10_1e may include a display panel and an input module, and in some cases, may further include a communication module.

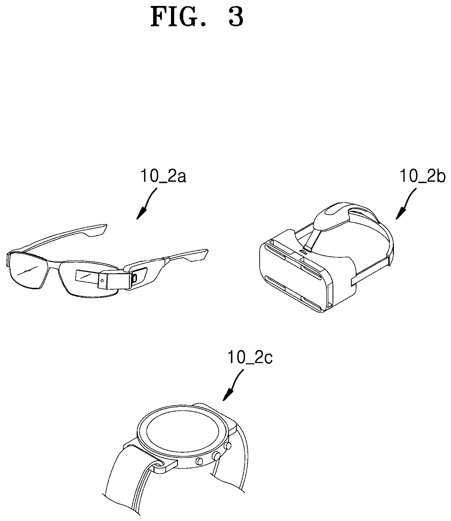

FIG. 3 shows a case where an electronic apparatus including a display panel is applied to a wearable electronic apparatus. The wearable electronic apparatus may include smart glasses 10_2a, a head-mounted display 10_2b, and a smart watch 10_2c.

The smart glasses 10_2a and the head-mounted display 10_2b may include a display panel that displays a display image, and a reflector that reflects a displayed display screen and provides it to a user's eyes, thereby providing a virtual reality and/or augmented reality screen to the user.

The smart watch 10_2c may include a biometric sensor as an input apparatus, and may provide biometric information recognized by a biometric sensor to a user through a display panel.

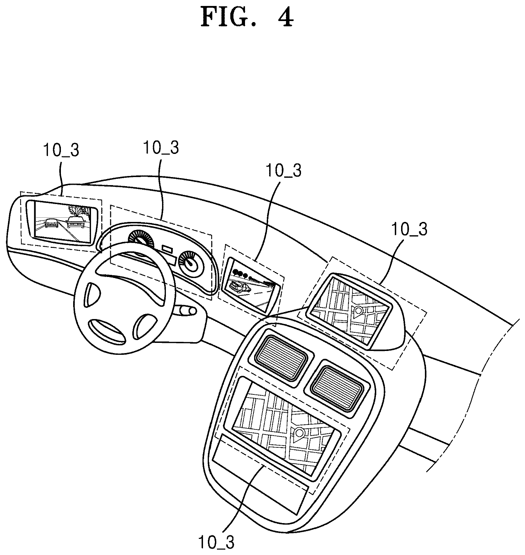

FIG. 4 shows a case where an electronic apparatus including a display panel is applied to a vehicle. For example, an electronic apparatus 10_3 may be applied to an instrument panel of a vehicle or a center fascia, or may be applied to a center information display (CID) arranged on the dashboard of a vehicle and/or a room mirror display in place of side-view mirrors.

In one or more embodiments, an electronic apparatus to which a display apparatus is applied may include not only apparatuses focused on screen display, such as billboards, electronic billboards, and/or game device, but also one or more suitable home appliances that display information through a display panel, such as refrigerators, washing machines, dryers, air conditioners, and/or robot vacuums. In addition, if (e.g., when) a display panel has a function of transmitting light, the display panel may be applied to an electronic apparatus, such as a smart window and/or a transparent display apparatus that displays a background and a display image together. The types (kinds) of electronic apparatuses according to one or more embodiments are not limited to the examples provided above, and the application of other one or more suitable electronic apparatuses that are not provided as examples is also possible.

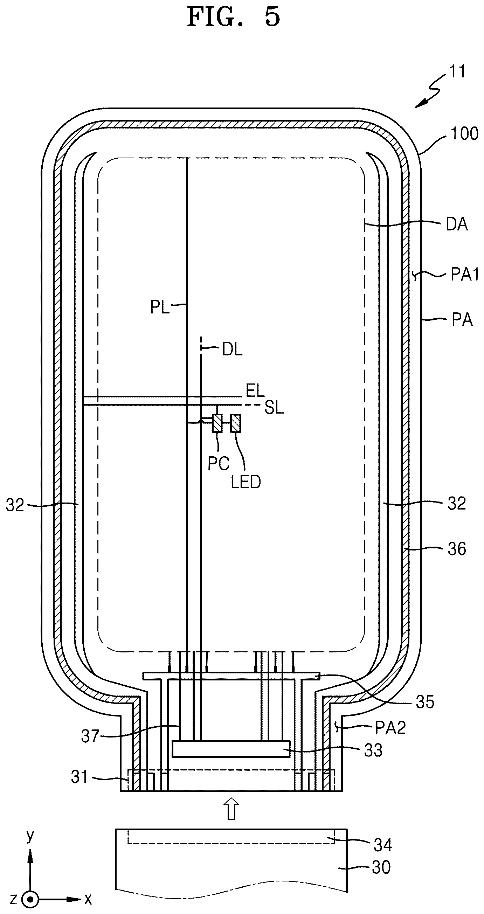

FIG. 5 is a schematic plan view of a display panel according to one or more embodiments.

Referring to FIG. 5, the display panel 11 may include a display area DA and a peripheral area PA outside the display area DA. The display area DA is an area where an image is displayed, and is where a plurality of pixels may be arranged. The display area DA may have one or more suitable shapes, such as a circle, an ellipse, a polygon, and/or a specific shape. For example, FIG. 5 shows that the display area DA has a roughly rectangular shape with rounded corners.

The peripheral area PA may be arranged outside the display area DA. The peripheral area PA may include: a first peripheral area PA1 around (e.g., surrounding) at least a portion of the display area DA; and a second peripheral area PA2 adjacent to one side of the display area DA and extending in a y direction. The width of the second peripheral area PA2 in an x direction may be smaller than the width of the display area DA. This structure makes it easier to bend at least a portion of the second peripheral area PA2. In one or more embodiments, the display panel 11 may be bent around (e.g., surrounding) a bending axis that crosses the second peripheral area PA2.

The shape of the plane of the display panel 11 shown in FIG. 5 may be substantially the same as the shape of a substrate 100 included in the display panel 11. If (e.g., when) the display panel 11 includes the display area DA and the peripheral area PA outside the display area DA, it may substantially refer to that the substrate 100 includes the display area DA and the peripheral area PA outside the display area DA, or the display area DA and the peripheral area PA outside the display area DA are defined on the substrate 100. Hereinafter, for convenience of explanation, it is described that the substrate 100 includes the display area DA and the peripheral area PA.

The substrate 100 may include glass, a metal, and/or polymer resin. The substrate 100 may include, for example, polymer resin, such as polyethersulfone, polyacrylate, polyetherimide, polyethylene naphthalate, polyethylene terephthalate, polyphenylene sulfide, polyarylate, polyimide, polycarbonate, and/or cellulose acetate propionate. The substrate 100 may have a multilayer structure including two layers including the above-described polymer resin and an inorganic layer arranged between the two layers.

Pixels may be at (e.g., arranged in) the display area DA. The display panel 11 may provide an image through light emitted from a pixel (or a sub-pixel).

In one or more embodiments, each of the pixels may include a plurality of sub-pixels. The sub-pixels may be to emit different light from one another. In one or more embodiments, one pixel may include a red sub-pixel, a green sub-pixel, and/or a blue sub-pixel. In one or more embodiments, one pixel may include a red sub-pixel, a green sub-pixel, a blue sub-pixel, and/or a white sub-pixel. Each of the sub-pixels may include a pixel circuit PC and a light-emitting diode LED electrically connected to the pixel circuit PC.

In one or more embodiments, each of the pixels may include one pixel circuit PC and one light-emitting diode LED. A plurality of pixels that is to emit a different light from one another may be arranged in the display area DA. In one or more embodiments, a red pixel, a green pixel, and/or a blue pixel may be arranged in the display area DA. In one or more embodiments, a red pixel, a green pixel, a blue pixel, and/or a white pixel may be arranged in the display area DA.

In the present specification, the term "pixel" may refer to a pixel including a plurality of sub-pixels, each of the plurality of sub-pixels including the light-emitting diode LED, or may refer to a pixel including one light-emitting diode LED.

A pad portion 31, a scan driver 32, a data driver 33, a driving voltage supply wiring 35, a common voltage supply wiring 36, and an input line 37 may be at (e.g., arranged in) the peripheral area PA.

The scan driver 32 may provide a scan signal to a sub-pixel circuit PCs through a scan line SL. The scan line SL may be a gate line connected to gates of switching transistors included in the pixel circuit PC. The scan signal may be a gate signal that turns on or turns off the switching transistors included in the pixel circuit PC. The scan driver 32 may be arranged on both sides (e.g., opposite sides) of the peripheral area PA with the display area DA therebetween. Some of the pixel circuits PC at the display area DA may be electrically connected to the scan driver 32 arranged in -x direction, and the others may be electrically connected to the scan driver 32 at a +x direction. In one or more embodiments, the scan driver 32 may be arranged on only one side of the peripheral area PA.

The pad portion 31 may be at (e.g., arranged in) the second peripheral area PA2 of the substrate 100. The pad portion 31 may be exposed without being covered by an insulating layer and may be electrically connected to a display circuit board 30. A pad portion 34 of the display circuit board 30 may be electrically connected to the pad portion 31 of the display panel 11.

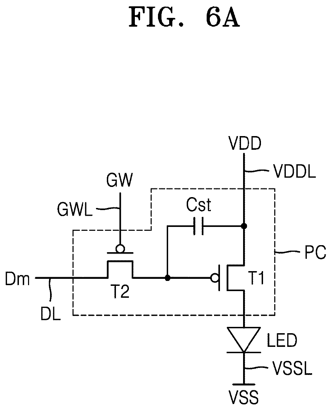

The display circuit board 30 may be to transmit a control signal to the display panel 11. The control signal may be transmitted to the scan driver 32 and the data driver 33 through the display circuit board 30. In one or more embodiments, the display circuit board 30 may include a power management integrated circuit (power management IC). The power management IC may provide a first power voltage VDD (see FIG. 6A) and a second power voltage VSS (see FIG. 6A) to the driving voltage supply wiring 35 and the common voltage supply wiring 36, respectively. The first power voltage VDD may be provided to each of the pixel circuits PC through a driving voltage line PL connected to the driving voltage supply wiring 35, and the second power voltage VSS may be provided to an opposite electrode of the light-emitting diode LED connected to the common voltage supply wiring 36. The driving voltage supply wiring 35 may extend in the x direction. The common voltage supply wiring 36 may have a loop shape of which one side is open, and may partially be around (e.g., surrounding) the display area DA.

A data signal of the data driver 33 may be transmitted to the pixel circuit PC through the input line 37 and a data line DL electrically connected to the input line 37.

FIGS. 6A to 6C are each an equivalent circuit diagram of a pixel of a display panel according to one or more embodiments.

Referring to FIG. 6A, the light-emitting diode LED corresponding to a pixel may be electrically connected to the pixel circuit PC. The pixel circuit PC may include a first transistor T1, a second transistor T2, and a storage capacitor Cst. The pixel circuit PC may be electrically connected to a signal line and a voltage line. The signal line may include a scan signal line GWL and the data line DL, and the voltage line may include a first voltage line VDDL.

The second transistor T2, as a data write transistor, may be electrically connected to the scan signal line GWL and the data line DL. The scan signal line GWL may be configured to provide a scan signal GW to a gate electrode of the second transistor T2. The second transistor T2 may be configured to transmit, to the first transistor T1, a data signal DM input from the data line DL according to the scan signal GW input from the scan signal line GWL.

The storage capacitor Cst may be electrically connected to the second transistor T2 and the first voltage line VDDL, and may store a voltage corresponding to a difference between a voltage received from the second transistor T2 and the first power voltage VDD supplied by the first voltage line VDDL.

The first transistor T1, as a driving transistor, may be configured to control a driving current flowing through the light-emitting diode LED. The first transistor T1 may be connected to the first voltage line VDDL and the storage capacitor Cst. The first transistor T1 may be configured to control a driving current flowing from the first voltage line VDDL to the light-emitting diode LED according to a voltage value stored in the storage capacitor Cst. The light-emitting diode LED may be to emit light having a certain luminance according to the driving current. A first electrode (for example, a pixel electrode or an anode) of the light-emitting diode LED may be electrically connected to the first transistor T1, and a second electrode (for example, an opposite electrode or a cathode) of the light-emitting diode LED may be electrically connected to a second voltage line VSSL that supplies the second power voltage VSS.

FIG. 6A shows that the pixel circuit PC includes one switching transistor (for example, the second transistor T2) and one capacitor (for example, the storage capacitor Cst), but in one or more embodiments, the pixel circuit PC may include two or more switching transistors and/or two or more capacitors.

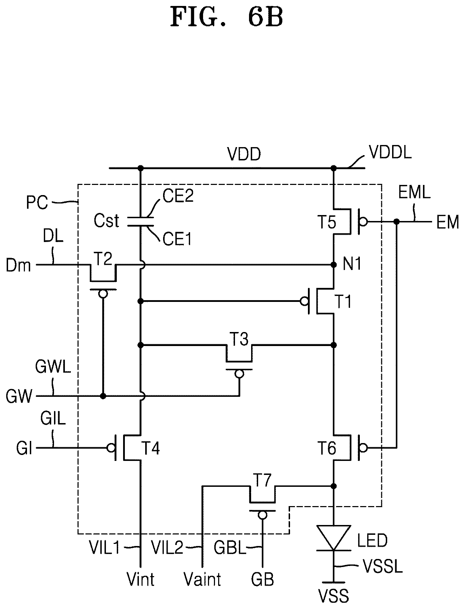

Referring to FIG. 6B, the pixel circuit PC may include the first transistor T1, the second transistor T2, a third transistor T3, a fourth transistor T4, a fifth transistor T5, a sixth transistor T6, a seventh transistor T7, and the storage capacitor Cst. The first transistor T1 may be a driving transistor, and the second transistor T2, the third transistor T3, the fourth transistor T4, the fifth transistor T5, the sixth transistor T6, and the seventh transistor T7 may each be a switching transistor.

The pixel circuit PC may be electrically connected to signal lines and voltage lines. The signal lines may include a gate line, such as the scan signal line GWL, a bypass control line GBL, an initialization control line GIL, and an emission control line EML, and the data line DL. The voltage lines may include first and second initialization voltage lines VIL1 and VIL2 and the first voltage line VDDL.

The first voltage line VDDL may be configured to transmit the first power voltage VDD to the first transistor T1. The first initialization voltage line VIL1 may be configured to transmit, to the pixel circuit PC, a first initialization voltage Vint that initializes the first transistor T1. The second initialization voltage line VIL2 may be configured to transmit, to the pixel circuit PC, a second initialization voltage Vaint that initializes the first electrode (for example, the pixel electrode or the anode) of the light-emitting diode LED.

The first transistor T1 may be electrically connected to the first voltage line VDDL via the fifth transistor T5 and may be electrically connected to the light-emitting diode LED via the sixth transistor T6. The first transistor T1 may act as a driving transistor and may be configured to receive the data signal DM according to a switching operation of the second transistor T2 and supply a driving current to the light-emitting diode LED.

The second transistor T2, as a data write transistor, may be electrically connected to the scan signal line GWL and the data line DL. The second transistor T2 may be electrically connected to the first voltage line VDDL via the fifth transistor T5. The second transistor T2 may be turned on according to the scan signal GW received through the scan signal line GWL and may be configured to perform a switching operation to transmit, to a first node N1, the data signal DM transmitted to the data line DL.

The third transistor T3 may be electrically connected to the scan signal line GWL and may be electrically connected to the light-emitting diode LED via the sixth transistor T6. The third transistor T3 may be turned on according to the scan signal GW received through the scan signal line GWL and may be configured to diode-connect the first transistor T1.

The fourth transistor T4, as a first initialization transistor, may be electrically connected to the initialization control line GIL and the first initialization voltage line VIL1. The fourth transistor T4 may be turned on according to an initialization control signal GI received through the initialization control line GIL and may be configured to transmit the first initialization voltage Vint from the first initialization voltage line VIL1 to a gate of the first transistor T1 and initialize a voltage of the gate of the first transistor T1. The initialization control signal GI may correspond to a scan signal of another pixel circuit arranged in a previous row of the corresponding pixel circuit PC.

The fifth transistor T5 may be an operation control transistor, and the sixth transistor T6 may be an emission control transistor. The fifth transistor T5 and the sixth transistor T6 may be electrically connected to the emission control line EML and may be concurrently (e.g., simultaneously) turned on according to an emission control signal EM received through the emission control line EML, thereby forming a current path that allows a driving current to flow from the first voltage line VDDL to the light-emitting diode LED. The first electrode of the light-emitting diode LED may be electrically connected to the first transistor T1 through the sixth transistor T6, and the second electrode of the light-emitting diode LED may be electrically connected to the second voltage line VSSL that supplies the second power voltage VSS.

The seventh transistor T7, as a second initialization transistor, may be electrically connected to the bypass control line GBL, the second initialization voltage line VIL2, and the sixth transistor T6. The seventh transistor T7 may be turned on according to a bypass control signal GB received through the bypass control line GBL and may be configured to transmit the second initialization voltage Vaint from the second initialization voltage line VIL2 to the first electrode of the light-emitting diode LED and initialize the first electrode of the light-emitting diode LED.

The storage capacitor Cst may include a first capacitor electrode CE1 and a second capacitor electrode CE2. The first capacitor electrode CE1 may be electrically connected to the gate of the first transistor T1, and the second capacitor electrode CE2 may be electrically connected to the first voltage line VDDL. The storage capacitor Cst may maintain a voltage applied to the gate of the first transistor T1 by storing and maintaining a voltage corresponding to a voltage difference between the first voltage line VDDL and the gate of the first transistor T1.

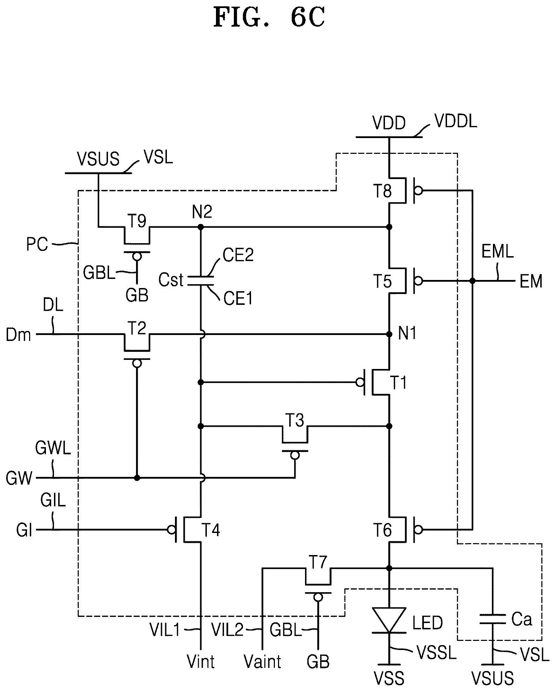

Referring to FIG. 6C, the pixel circuit PC may include the first transistor T1, the second transistor T2, the third transistor T3, the fourth transistor T4, the fifth transistor T5, the sixth transistor T6, the seventh transistor T7, an eighth transistor T8, a ninth transistor T9, the storage capacitor Cst, and an auxiliary capacitor Ca. The first transistor T1 may be a driving transistor, and the second transistor T2, the third transistor T3, the fourth transistor T4, the fifth transistor T5, the sixth transistor T6, the seventh transistor T7, the eighth transistor T8, and the ninth transistor T9 may each be a switching transistor.

The pixel circuit PC may be electrically connected to signal lines and voltage lines. The signal lines may include a gate line, such as the scan signal line GWL, the bypass control line GBL, the initialization control line GIL, and the emission control line EML, and the data line DL. The voltage lines may include the first and second initialization voltage lines VIL1 and VIL2, a sustain voltage line VSL, and the first voltage line VDDL.

The first voltage line VDDL may be configured to transmit the first power voltage VDD to the first transistor T1. The first initialization voltage line VIL1 may be configured to transmit, to the pixel circuit PC, the first initialization voltage Vint that initializes the first transistor T1. The second initialization voltage line VIL2 may be configured to transmit, to the pixel circuit PC, the second initialization voltage Vaint that initializes the first electrode of the light-emitting diode LED. The sustain voltage line VSL may be configured to provide a sustain voltage VSUS to a second node N2, for example, the second capacitor electrode CE2 of the storage capacitor Cst, during an initialization period and a data write period.

The first transistor T1 may be electrically connected to the first voltage line VDDL via the fifth transistor T5 and the eighth transistor T8 and may be electrically connected to the light-emitting diode LED via the sixth transistor T6. The first transistor T1 may act as a driving transistor and may be configured to receive the data signal DM according to a switching operation of the second transistor T2 and supply a driving current to the light-emitting diode LED.

The second transistor T2 may be electrically connected to the scan signal line GWL and the data line DL and may be electrically connected to the first voltage line VDDL via the fifth transistor T5 and the eighth transistor T8. The second transistor T2 may be turned on according to the scan signal GW received through the scan signal line GWL and may be configured to perform a switching operation to transmit, to the first node N1, the data signal DM transmitted to the data line DL.

The third transistor T3 may be electrically connected to the scan signal line GWL and may be electrically connected to the light-emitting diode LED via the sixth transistor T6. The third transistor T3 may be turned on according to the scan signal GW received through the scan signal line GWL and may be configured to compensate for a threshold voltage of the first transistor T1 by diode-connecting the first transistor T1.

The fourth transistor T4 may be electrically connected to the initialization control line GIL and the first initialization voltage line VIL1, and may be turned on according to the initialization control signal GI received through the initialization control line GIL and may be configured to transmit the first initialization voltage Vint from the first initialization voltage line VIL1 to the gate of the first transistor T1 and initialize a voltage of the gate of the first transistor T1. The initialization control signal GI may correspond to a scan signal of another pixel circuit arranged in a previous row of the corresponding pixel circuit PC.

The fifth transistor T5, the sixth transistor T6, and the eighth transistor T8 may be electrically connected to the emission control line EML and may be concurrently (e.g., simultaneously) turned on according to the emission control signal EM received through the emission control line EML, thereby forming a current path that allows a driving current to flow from the first voltage line VDDL to the light-emitting diode LED. The first electrode of the light-emitting diode LED may be electrically connected to the first transistor T1 through the sixth transistor T6, and the second electrode of the light-emitting diode LED may be electrically connected to the second voltage line VSSL that supplies the second power voltage VSS.

The seventh transistor T7, as a second initialization transistor, may be electrically connected to the bypass control line GBL, the second initialization voltage line VIL2, and the sixth transistor T6. The seventh transistor T7 may be turned on according to the bypass control signal GB received through the bypass control line GBL and may be configured to transmit the second initialization voltage Vaint from the second initialization voltage line VIL2 to the first electrode of the light-emitting diode LED and initialize the first electrode of the light-emitting diode LED.

The ninth transistor T9 may be electrically connected to the bypass control line GBL, the second capacitor electrode CE2 of the storage capacitor Cst, and the sustain voltage line VSL. The ninth transistor T9 may be turned on according to the bypass control signal GB received through the bypass control line GBL and may be configured to transmit the sustain voltage VSUS to the second node N2, for example, the second capacitor electrode CE2 of the storage capacitor Cst, during the initialization period and the data write period.

Each of the eighth transistor T8 and the ninth transistor T9 may be electrically connected to the second node N2, for example, the second capacitor electrode CE2 of the storage capacitor Cst. In one or more embodiments, the eighth transistor T8 may be turned off and the ninth transistor T9 may be turned on during the initialization period and the data write period, and the eighth transistor T8 may be turned on and the ninth transistor T9 may be turned off during an emission period.

The storage capacitor Cst may include the first capacitor electrode CE1 and the second capacitor electrode CE2. The first capacitor electrode CE1 may be electrically connected to the gate of the first transistor T1, and the second capacitor electrode CE2 may be electrically connected to the eighth transistor T8 and the ninth transistor T9.

The auxiliary capacitor Ca may be electrically connected to the sixth transistor T6, the sustain voltage line VSL, and the first electrode of the light-emitting diode LED. The auxiliary capacitor Ca may store and maintain a voltage corresponding to a voltage difference between the first electrode of the light-emitting diode LED and the sustain voltage line VSL while the seventh transistor T7 and the ninth transistor T9 are turned on, thereby preventing or reducing an increase in black luminance if (e.g., when) the sixth transistor T6 is in an off state.

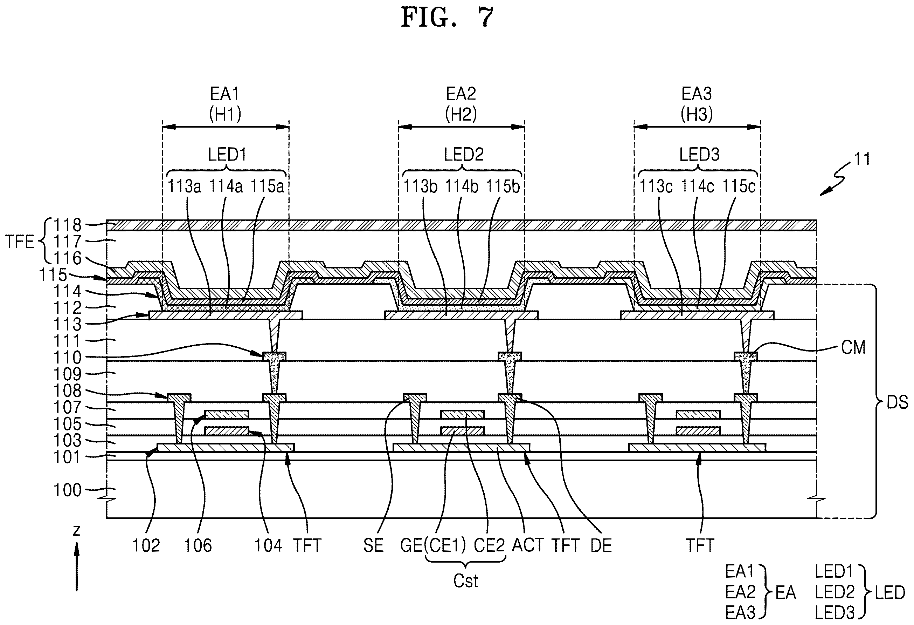

FIG. 7 is a cross-sectional view of a display panel according to one or more embodiments.

Referring to FIG. 7, a plurality of emission areas EA may be defined on the substrate 100. In one or more embodiments, a first emission area EA1, a second emission area EA2, and a third emission area EA3 may be defined on the substrate 100. The first emission area EA1, the second emission area EA2, and the third emission area EA3 may be spaced and/or apart (e.g., spaced apart or separated) from one another.

The display panel 11 may include a plurality of light-emitting diodes LED corresponding to the plurality of emission areas EA. In one or more embodiments, the display panel 11 may include a first light-emitting diode LED1 corresponding to the first emission area EA1, a second light-emitting diode LED2 corresponding to the second emission area EA2, and a third light-emitting diode LED3 corresponding to the third emission area EA3.

The display panel 11 may include thin-film transistors TFT corresponding to the light-emitting diodes LED respectively. Each of the light-emitting diodes LED may be electrically connected to the corresponding thin-film transistor TFT. Each of the thin-film transistors TFT shown in FIG. 7 may schematically represent a portion of the pixel circuit PC described with reference to FIGS. 6A to 6C. In one or more embodiments, each thin-film transistor TFT may correspond to the first transistor T1 of FIG. 6A, the first transistor T1 or the sixth transistor T6 of FIG. 6B, or the first transistor T1 or the sixth transistor T6 of FIG. 6C.

Light may be emitted from the emission areas EA through light emitted from the light-emitting diodes LED. In one or more embodiments, the emission areas EA may be to emit light through light emitted from the light-emitting diodes LED. In one or more embodiments, areas where light is emitted from the light-emitting diodes LED may be understood as the emission areas EA. The display panel 11 may display an image through light emitted from the emission areas EA or the light-emitting diodes LED.

In one or more embodiments, light of different colors may be emitted from the emission areas EA. In one or more embodiments, the first emission area EA1 and the first light-emitting diode LED1 may be to emit red light. In one or more embodiments, the second emission area EA2 and the second light-emitting diode LED2 may be to emit green light. In one or more embodiments, the third emission area EA3 and the third light-emitting diode LED3 may be to emit blue light.

A first insulating layer 101 may be arranged on the substrate 100. The first insulating layer 101 may entirely or substantially cover the substrate 100. The first insulating layer 101 may be planarized (e.g., be planar) and protect a top surface of the substrate 100. The first insulating layer 101 may include an inorganic insulating material. In one or more embodiments, the first insulating layer 101 may include at least one of inorganic insulating materials such as silicon oxide (e.g., SiO₂), silicon nitride (e.g., SiNₓ), silicon oxynitride (e.g., SiON), aluminum oxide (e.g.,Al₂O₃), titanium oxide (e.g., TiO₂), tantalum oxide (e.g., Ta₂O₅), hafnium oxide (e.g., HfO₂), and/or zinc oxide (e.g., ZnO₂), and may have a single-layer structure or a multilayer structure, each including the above-described material. In one or more embodiments, the first insulating layer 101 may be a buffer layer.

Each thin-film transistor TFT may be arranged on the first insulating layer 101. Each thin-film transistor TFT may include an active layer ACT, a gate electrode GE, a source electrode SE, and a drain electrode DE. The thin-film transistors TFT respectively corresponding to the first to third light-emitting diodes LED1, LED2, and LED3 may be arranged on the first insulating layer 101. The structures of the thin-film transistors TFT corresponding to the first to third light-emitting diodes LED1, LED2, and LED3 may be similar to one another.

A semiconductor layer 102 may be arranged on the first insulating layer 101. The semiconductor layer 102 may include the active layer ACT. The active layers ACT may be patterned to correspond to the thin-film transistors TFT respectively. The active layer ACT may include a drain area overlapping the drain electrode DE, a source area overlapping the source electrode SE, and a channel area between the drain area and the source area. The drain area and the source area may be areas doped with impurities (e.g., dopant).

A second insulating layer 103 may be arranged on the semiconductor layer 102. The second insulating layer 103 may include an inorganic insulating material. In one or more embodiments, the second insulating layer 103 may include at least one of inorganic insulating materials such as silicon oxide (e.g., SiO₂), silicon nitride (e.g., SiNₓ), silicon oxynitride (e.g., SiON), aluminum oxide (e.g., Al₂O₃), titanium oxide (e.g., TiO₂), tantalum oxide (e.g., Ta₂O₅), hafnium oxide (e.g., HfO₂), and/or zinc oxide (e.g., ZnO₂), and may have a single-layer structure or a multilayer structure, each including the above-described material. In one or more embodiments, the second insulating layer 103 may be a first gate insulating layer. In one or more embodiments, as shown in FIG. 7, the second insulating layer 103 may entirely cover the semiconductor layer 102 and the first insulating layer 101. In one or more embodiments, the second insulating layer 103 may be patterned to cover only each of the active layers ACT and not to cover a top surface of the first insulating layer 101 between the active layers ACT. In one or more embodiments, the second insulating layer 103 may be patterned to cover only a partial area (for example, an area overlapping the gate electrode GE, e.g., the channel area) of each of the active layers ACT.

Storage capacitors Cst may be arranged on the second insulating layer 103. Each of the storage capacitors Cst may include the first capacitor electrode CE1 and the second capacitor electrode CE2. The second capacitor electrode CE2 may be arranged on the first capacitor electrode CE1.

A first conductive layer 104 may be arranged on the second insulating layer 103. The first conductive layer 104 may include the gate electrode GE and the first capacitor electrode CE1. The gate electrodes GE may be patterned to correspond to the thin-film transistors TFT respectively. The gate electrode GE may overlap the channel area of the active layer ACT. The first capacitor electrodes CE1 may be patterned to correspond to the storage capacitors Cst respectively. In one or more embodiments, the gate electrode GE and the first capacitor electrode CE1 may be integrally provided as a single body as shown in FIG. 7. In one or more embodiments, the gate electrode GE and the first capacitor electrode CE1 may be provided separately. In one or more embodiments, the first conductive layer 104 may include at least one of aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single-layer structure or a multilayer structure, each including the above-described material.

A third insulating layer 105 may be arranged on the first conductive layer 104. The third insulating layer 105 may entirely cover the first conductive layer 104. The third insulating layer 105 may include an inorganic insulating material. In one or more embodiments, the third insulating layer 105 may include at least one of inorganic insulating materials such as silicon oxide (e.g., SiO₂), silicon nitride (e.g., SiNₓ), silicon oxynitride (e.g., SiON), aluminum oxide (e.g., Al₂O₃), titanium oxide (e.g., TiO₂), tantalum oxide (e.g., Ta₂O₅), hafnium oxide (e.g., HfO₂), and/or zinc oxide (e.g., ZnO₂), and may have a single-layer structure or a multilayer structure, each including the above-described material. In one or more embodiments, the third insulating layer 105 may be a second gate insulating layer.

A second conductive layer 106 may be arranged on the third insulating layer 105. The second conductive layer 106 may include the second capacitor electrode CE2 of each storage capacitor Cst. The second capacitor electrodes CE2 may be patterned to correspond to the storage capacitors Cst respectively. The second capacitor electrode CE2 may overlap the first capacitor electrode CE1. In one or more embodiments, the second conductive layer 106 may include at least one of aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single-layer structure or a multilayer structure, each including the above-described material.

A fourth insulating layer 107 may be arranged on the second conductive layer 106. The fourth insulating layer 107 may entirely or substantially cover the second conductive layer 106. The fourth insulating layer 107 may include an inorganic insulating material. In one or more embodiments, the fourth insulating layer 107 may include at least one of inorganic insulating materials such as silicon oxide (e.g., SiO₂), silicon nitride (e.g., SiNₓ), silicon oxynitride (e.g., SiON), aluminum oxide (e.g., Al₂O₃), titanium oxide (e.g., TiO₂), tantalum oxide (e.g., Ta₂O₅), hafnium oxide (e.g., HfO₂), and/or zinc oxide (e.g., ZnO₂), and may have a single-layer structure or a multilayer structure, each including the above-described material. In one or more embodiments, the fourth insulating layer 107 may be an interlayer insulating layer.

A third conductive layer 108 may be arranged on the fourth insulating layer 107. The third conductive layer 108 may include the source electrode SE and the drain electrode DE of each thin-film transistor TFT. The source electrodes SE and the drain electrodes DE may each be patterned to correspond to the respective one of the thin-film transistors TFT. The source electrode SE may overlap the source area of the active layer ACT. The drain electrode DE may overlap the drain area of the active layer ACT. The source electrode SE may be connected to the active layer ACT (for example, the source area of the active layer ACT) through an opening defined in the second to fourth insulating layers 103, 105, and 107. The drain electrode DE may be connected to the active layer ACT (for example, the drain area of the active layer ACT) through an opening defined in the second to fourth insulating layers 103, 105, and 107. In one or more embodiments, the third conductive layer 108 may include at least one of aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single-layer structure or a multilayer structure, each including the above-described material.

A fifth insulating layer 109 may be arranged on the third conductive layer 108. An opening overlapping the drain electrode DE may be defined in the fifth insulating layer 109. The fifth insulating layer 109 may include an organic insulating material. In one or more embodiments, the fifth insulating layer 109 may include an organic insulating material, such as a general purpose polymer such as benzocyclobutene, polyimide, hexamethyldisiloxane, polymethylmethacrylate, and/or polystyrene, a polymer derivative having a phenolic group, an acrylic polymer, an imide-based polymer, an aryl ether-based polymer, an amide-based polymer, a fluorine-based polymer, a p-xylene-based polymer, and/or a vinyl alcohol-based polymer, and may have a single-layer structure or a multilayer structure, each including the above-described material. In one or more embodiments, the fifth insulating layer 109 may be a first via layer.

A fourth conductive layer 110 may be arranged on the fifth insulating layer 109. The fourth conductive layer 110 may include contact metals CM corresponding to the first to third light-emitting diodes LED1, LED2, and LED3, respectively. Each of the contact metals CM may be patterned to overlap the corresponding light-emitting diode LED. Each of the contact metals CM may be connected to the corresponding drain electrode DE through an opening defined in the fifth insulating layer 109. In one or more embodiments, the fourth conductive layer 110 may include at least one of aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single-layer structure or a multilayer structure, each including the above-described material.

A sixth insulating layer 111 may be arranged on the fourth conductive layer 110. An opening overlapping each contract metal CM of the fourth conductive layer 110 may be defined in the sixth insulating layer 111. The sixth insulating layer 111 may include an organic insulating material. In one or more embodiments, the sixth insulating layer 111 may include an organic insulating material, such as a general purpose polymer such as benzocyclobutene, polyimide, hexamethyldisiloxane, polymethylmethacrylate, and/or polystyrene, a polymer derivative having a phenolic group, an acrylic polymer, an imide-based polymer, an aryl ether-based polymer, an amide-based polymer, a fluorine-based polymer, a p-xylene-based polymer, and/or a vinyl alcohol-based polymer, and may have a single-layer structure or a multilayer structure, each including the above-described material. In one or more embodiments, the sixth insulating layer 111 may be a second via layer.

The plurality of light-emitting diodes LED may be arranged on the sixth insulating layer 111. In one or more embodiments, the first to third light-emitting diodes LED1, LED2, and LED3 may be arranged on the sixth insulating layer 111. Each light-emitting diode LED may include a corresponding pixel electrode, intermediate layer, and opposite electrode. In one or more embodiments, the first light-emitting diode LED1 may include a first pixel electrode 113a, a first deposition pattern 114a, and a first opposite electrode 115a. In one or more embodiments, the second light-emitting diode LED2 may include a second pixel electrode 113b, a second deposition pattern 114b, and a second opposite electrode 115b. In one or more embodiments, the third light-emitting diode LED3 may include a third pixel electrode 113c, a third deposition pattern 114c, and a third opposite electrode 115c. The intermediate layer of each light-emitting diode LED may be to emit light through a current flowing through the intermediate layer due to a potential difference between the pixel electrode and the opposite electrode, and accordingly, each light-emitting diode LED may be to emit light.

A fifth conductive layer 113 may be arranged on the sixth insulating layer 111. The fifth conductive layer 113 may include the first pixel electrode 113a, the second pixel electrode 113b, and the third pixel electrode 113c. The first pixel electrode 113a, the second pixel electrode 113b, and the third pixel electrode 113c may be patterned separately and spaced and/or apart (e.g., spaced apart or separated) from one another. Each of the first pixel electrode 113a, the second pixel electrode 113b, and the third pixel electrode 113c may be connected to the corresponding thin-film transistor TFT through the corresponding contact metal CM and drain electrode DE. In one or more embodiments, the fifth conductive layer 113 may include a conductive oxide such as indium tin oxide (ITO), indium zinc oxide (IZO), zinc oxide (ZnO), indium oxide (In₂O₃), indium gallium oxide (IGO), and/or aluminum zinc oxide (AZO). In one or more embodiments, the fifth conductive layer 113 may include a reflective film including silver (Ag), magnesium (Mg), aluminum (Al), platinum (Pt), palladium (Pd), gold (Au), nickel (Ni), neodymium (Nd), iridium (Ir), chromium (Cr), and/or compounds thereof. The composition and material of the fifth conductive layer 113 are not limited thereto, and one or more suitable modifications are possible.

A pixel-defining layer 112 may be arranged on the fifth conductive layer 113 and the sixth insulating layer 111. The pixel-defining layer 112 may include a plurality of holes overlapping a plurality of pixel electrodes of the fifth conductive layer 113. For example, the pixel-defining layer 112 may cover an edge (or an edge area) of each of the pixel electrodes of the fifth conductive layer 113. In one or more embodiments, the pixel-defining layer 112 may include a first hole H1 overlapping the first pixel electrode 113a. For example, the pixel-defining layer 112 may cover an edge (or an edge area) of the first pixel electrode 113a. In one or more embodiments, the pixel-defining layer 112 may include a second hole H2 overlapping the second pixel electrode 113b. For example, the pixel-defining layer 112 may cover an edge (or an edge area) of the second pixel electrode 113b. In one or more embodiments, the pixel-defining layer 112 may include a third hole H3 overlapping the third pixel electrode 113c. For example, the pixel-defining layer 112 may cover an edge (or an edge area) of the third pixel electrode 113c.

An intermediate layer 114 may be arranged (for example, deposited) on the pixel-defining layer 112 and the fifth conductive layer 113. The intermediate layer 114 may include the first deposition pattern 114a, the second deposition pattern 114b, and the third deposition pattern 114c.

In one or more embodiments, the intermediate layer 114 may include an emission layer and a functional layer. The emission layer may include a low-molecular-weight material and/or a polymer material that emits light if (e.g., when) a certain voltage is applied (or if (e.g., when) a certain current flows). The functional layer may include at least one of an electron transport layer (ETL), an electron injection layer (EIL), a hole transport layer (HTL), and/or a hole injection layer (HIL). Each of the first deposition pattern 114a, the second deposition pattern 114b, and the third deposition pattern 114c may include an emission layer and a functional layer.

In one or more embodiments, the emission layers respectively included in the first deposition pattern 114a, the second deposition pattern 114b, and the third deposition pattern 114c may include different materials from one another. For example, the emission layers respectively included in the first deposition pattern 114a, the second deposition pattern 114b, and the third deposition pattern 114c may be to emit light of different wavelengths (e.g., colors). In one or more embodiments, the emission layer included in the first deposition pattern 114a may be to emit red light if (e.g., when) a current flows. In one or more embodiments, the emission layer included in the second deposition pattern 114b may be to emit green light if (e.g., when) a current flows. In one or more embodiments, the emission layer included in the third deposition pattern 114c may be to emit blue light if (e.g., when) a current flows.

The first deposition pattern 114a may overlap the first pixel electrode 113a. One portion (for example, a first portion) of the first deposition pattern 114a may be arranged in the first hole H1 in the pixel-defining layer 112 and may be in contact with the first pixel electrode 113a. The other portion (for example, a second portion) of the first deposition pattern 114a may be arranged on the pixel-defining layer 112. The first and second portions of the first deposition pattern 114a may be connected to each other. For example, the first portion of the first deposition pattern 114a may be connected to the second portion of the first deposition pattern 114a. That is, the first deposition pattern 114a may cover an edge of the pixel-defining layer 112, which defines the first hole H1.

The second deposition pattern 114b may overlap the second pixel electrode 113b. One portion (for example, a first portion) of the second deposition pattern 114b may be arranged in the second hole H2 in the pixel-defining layer 112 and may be in contact with the second pixel electrode 113b. The other portion (for example, a second portion) of the second deposition pattern 114b may be arranged on the pixel-defining layer 112. The first and second portions of the second deposition pattern 114b may be connected to each other. For example, the first portion of the second deposition pattern 114b may be connected to the second portion of the second deposition pattern 114b. That is, the second deposition pattern 114b may cover an edge of the pixel-defining layer 112, which defines the second hole H2. For examples, one portion of the second deposition pattern 114b is arranged in the second hole H2 of the pixel-defining layer 112 and contacts the second pixel electrode 113b. Another portion of the second deposition pattern 114b is arranged on the pixel-defining layer 112. These portions are connected, with the second deposition pattern 114b covering the edge of the pixel-defining layer 112 that defines the second hole H2.

The third deposition pattern 114c may overlap the third pixel electrode 113c. One portion (for example, a first portion) of the third deposition pattern 114c may be arranged in the third hole H3 in the pixel-defining layer 112 and may be in contact with the third pixel electrode 113c. The other portion (for example, a second portion) of the third deposition pattern 114c may be arranged on the pixel-defining layer 112. The first and second portions of the third deposition pattern 114c may be connected to each other. For example, the first portion of the third deposition pattern 114c may be connected to the second portion of the third deposition pattern 114c. That is, the third deposition pattern 114c may cover an edge of the pixel-defining layer 112, which defines the third hole H3. For example, one portion of the third deposition pattern 114c is arranged in the third hole H3 of the pixel-defining layer 112 and contacts the third pixel electrode 113c. Another portion of the third deposition pattern 114c is arranged on the pixel-defining layer 112. These portions are connected, with the third deposition pattern 114c covering the edge of the pixel-defining layer 112 that defines the third hole H3.

An opposite electrode 115 may be arranged on the intermediate layer 114. The opposite electrode 115 may be integrally formed on the first to third light-emitting diodes LED1, LED2, and LED3. The opposite electrode 115 may cover the intermediate layer 114. A portion of the opposite electrode 115, overlapping the first deposition pattern 114a, may be considered as the first opposite electrode 115a. In one or more embodiments, the first opposite electrode 115a may cover the first deposition pattern 114a. A portion of the opposite electrode 115, overlapping the second deposition pattern 114b, may be considered as the second opposite electrode 115b. In one or more embodiments, the second opposite electrode 115b may cover the second deposition pattern 114b. A portion of the opposite electrode 115, overlapping the third deposition pattern 114c, may be considered as the third opposite electrode 115c. In one or more embodiments, the third opposite electrode 115c may cover the third deposition pattern 114c.

The opposite electrode 115 may include a conductive material. In one or more embodiments, the opposite electrode 115 may include a transparent layer (or a semi-transparent layer) including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), and/or alloys thereof. In one or more embodiments, the opposite electrode 115 may further include a layer including a material, such as indium tin oxide (ITO), indium zinc oxide (IZO), zinc oxide (ZnO), and/or indium oxide (In₂O₃), on the transparent layer (or the semi-transparent layer) including the above-described material.

The intermediate layer 114 may be to emit light through a current flowing through the intermediate layer 114 due to a potential difference between the fifth conductive layer 113 and the opposite electrode 115, for example, a difference between a voltage applied to the fifth conductive layer 113 and a voltage applied to the opposite electrode 115. In one or more embodiments, the first deposition pattern 114a may be to emit light through a current flowing through the first deposition pattern 114a due to a difference between a voltage applied to the first pixel electrode 113a and a voltage applied to the first opposite electrode 115a. In one or more embodiments, the second deposition pattern 114b may be to emit light through a current flowing through the second deposition pattern 114b due to a difference between a voltage applied to the second pixel electrode 113b and a voltage applied to the second opposite electrode 115b. In one or more embodiments, the third deposition pattern 114c may be to emit light through a current flowing through the third deposition pattern 114c due to a difference between a voltage applied to the third pixel electrode 113c and a voltage applied to the third opposite electrode 115c. In one or more embodiments, because the first opposite electrode 115a, the second opposite electrode 115b, and the third opposite electrode 115c may be integrally formed as a single body, the same voltage may be applied to the first opposite electrode 115a, the second opposite electrode 115b, and the third opposite electrode 115c.

For the current to flow through the first deposition pattern 114a due to a potential difference between the first pixel electrode 113a and the first opposite electrode 115a, the first deposition pattern 114a is desired or required to be in contact with the first pixel electrode 113a and the first opposite electrode 115a. Because the first deposition pattern 114a may entirely or substantially be in contact with the first opposite electrode 115a, the current may be to flow through the first deposition pattern 114a in an area in contact with the first pixel electrode 113a. The first deposition pattern 114a may be to emit light in the area in contact with the first pixel electrode 113a. Therefore, an area where the first deposition pattern 114a emits light, an area where the first light-emitting diode LED1 emits light, or the first emission area EA1 may be defined by an area where the first deposition pattern 114a and the first pixel electrode 113a are in contact with each other. In one or more embodiments, because the first deposition pattern 114a may be in contact with the first pixel electrode 113a within the first hole H1 in the pixel-defining layer 112, the area where the first deposition pattern 114a and the first pixel electrode 113a are in contact with each other may be defined by the first hole H1. Therefore, the first emission area EA1 may be defined by the first hole H1.

Because a portion of the first deposition pattern 114a may cover the edge of the pixel-defining layer 112, which defines the first hole H1, and may be arranged on a top surface of the pixel-defining layer 112, the shape or size of the first deposition pattern 114a may be different from the shape or size of the first hole H1 (or the first emission area EA1). In one or more embodiments, in plan view (for example, if (e.g., when) viewed in a z direction), the shape or size of the first deposition pattern 114a may be different from the shape or size of the first hole H1 (or the first emission area EA1). A specific relationship between the planar shape of the first deposition pattern 114a and the planar shape of the first hole H1 (or the first emission area EA1) is described in more detail .

Similarly, for the current to flow through the second deposition pattern 114b due to a potential difference between the second pixel electrode 113b and the second opposite electrode 115b, the second deposition pattern 114b is desired or required to be in contact with the second pixel electrode 113b and the second opposite electrode 115b. Because the second deposition pattern 114b may entirely or substantially be in contact with the second opposite electrode 115b, the current may flow through the second deposition pattern 114b in an area in contact with the second pixel electrode 113b. The second deposition pattern 114b may be to emit light in the area in contact with the second pixel electrode 113b. Therefore, an area where the second deposition pattern 114b emits light, an area where the second light-emitting diode LED2 emits light, or the second emission area EA2 may be defined by an area where the second deposition pattern 114b and the second pixel electrode 113b are in contact with each other. In one or more embodiments, because the second deposition pattern 114b may be in contact with the second pixel electrode 113b within the second hole H2 in the pixel-defining layer 112, the area where the second deposition pattern 114b and the second pixel electrode 113b are in contact with each other may be defined by the second hole H2. Therefore, the second emission area EA2 may be defined by the second hole H2.

Because a portion of the second deposition pattern 114b may cover the edge of the pixel-defining layer 112, which defines the second hole H2, and may be arranged on the top surface of the pixel-defining layer 112, the shape or size of the second deposition pattern 114b may be different from the shape or size of the second hole H2 (or the second emission area EA2). In one or more embodiments, in plan view (for example, if (e.g., when) viewed in the z direction), the shape or size of the second deposition pattern 114b may be different from the shape or size of the second hole H2 (or the second emission area EA2). A specific relationship between the planar shape of the second deposition pattern 114b and the planar shape of the second hole H2 (or the second emission area EA2) is described in more detail .

Similarly, for the current to flow through the third deposition pattern 114c due to a potential difference between the third pixel electrode 113c and the third opposite electrode 115c, the third deposition pattern 114c is desired or required to be in contact with the third pixel electrode 113c and the third opposite electrode 115c. Because the third deposition pattern 114c may entirely or substantially be in contact with the third opposite electrode 115c, the current may be to flow through the third deposition pattern 114c in an area in contact with the third pixel electrode 113c. The third deposition pattern 114c may be to emit light in the area in contact with the third pixel electrode 113c. Therefore, an area where the third deposition pattern 114c emits light, an area where the third light-emitting diode LED3 emits light, or the third emission area EA3 may be defined by an area where the third deposition pattern 114c and the third pixel electrode 113c are in contact with each other. In one or more embodiments, because the third deposition pattern 114c may be in contact with the third pixel electrode 113c within the third hole H3 in the pixel-defining layer 112, the area where the third deposition pattern 114c and the third pixel electrode 113c are in contact with each other may be defined by the third hole H3. Therefore, the third emission area EA3 may be defined by the third hole H3.

Because a portion of the third deposition pattern 114c may cover the edge of the pixel-defining layer 112, which defines the third hole H3, and may be arranged on the top surface of the pixel-defining layer 112, the shape or size of the third deposition pattern 114c may be different from the shape or size of the third hole H3 (or the third emission area EA3). In one or more embodiments, in plan view (for example, if (e.g., when) viewed in the z direction), the shape or size of the third deposition pattern 114c may be different from the shape or size of the third hole H3 (or the third emission area EA3). A specific relationship between the planar shape of the third deposition pattern 114c and the planar shape of the third hole H3 (or the third emission area EA3) is described in more detail .

A thin-film encapsulation layer TFE may be arranged on the opposite electrode 115. The thin-film encapsulation layer TFE may cover the first light-emitting diode LED1, the second light-emitting diode LED2, and the third light-emitting diode LED3. In one or more embodiments, the thin-film encapsulation layer TFE may include at least one inorganic layer and at least one organic layer. For example, as shown in FIG. 7, the thin-film encapsulation layer TFE may include a first inorganic encapsulation layer 116 arranged on the opposite electrode 115, an organic encapsulation layer 117 on the first inorganic encapsulation layer 116, and a second inorganic encapsulation layer 118 on the organic encapsulation layer 117. The first inorganic encapsulation layer 116 and the second inorganic encapsulation layer 118 may include an inorganic insulating material. In one or more embodiments, the first inorganic encapsulation layer 116 and/or the second inorganic encapsulation layer 118 may include at least one inorganic insulating material such as silicon oxide (e.g., SiO₂), silicon nitride (e.g., SiNₓ), silicon oxynitride (e.g., SiON), aluminum oxide (e.g., Al₂O₃), titanium oxide (e.g., TiO₂), tantalum oxide (e.g., Ta₂O₅), hafnium oxide (e.g., HfO₂), and/or zinc oxide (e.g., ZnO₂). The organic encapsulation layer 117 may include an organic insulating material. In one or more embodiments, the organic encapsulation layer 117 may include a polymer-based material. Examples of the polymer-based material may include silicone resin, acrylic resin, epoxy resin, polyimide, and/or polyethylene. In one or more embodiments, the organic encapsulation layer 117 may be provided as a planarization layer with a flat top surface.

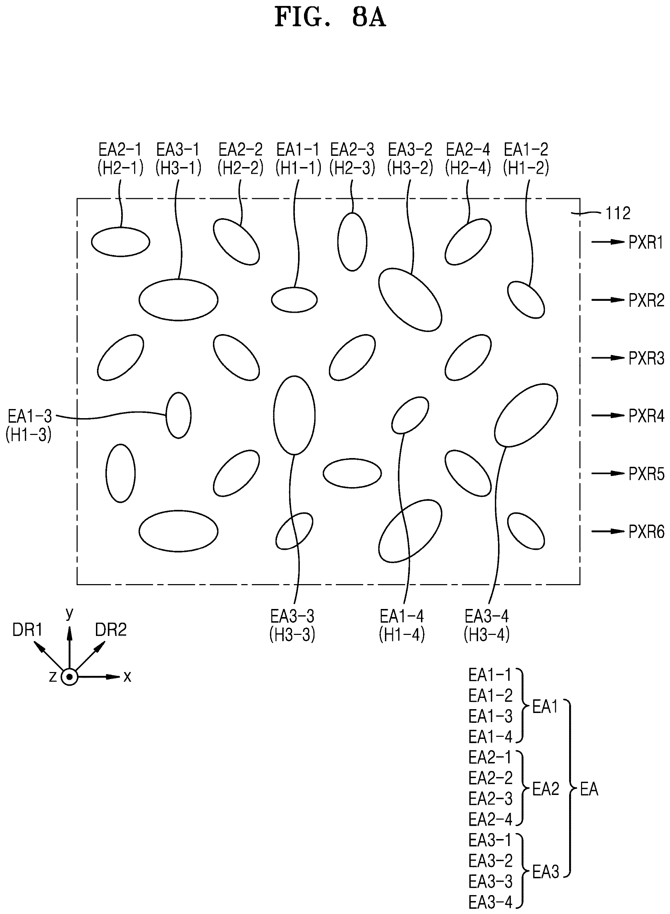

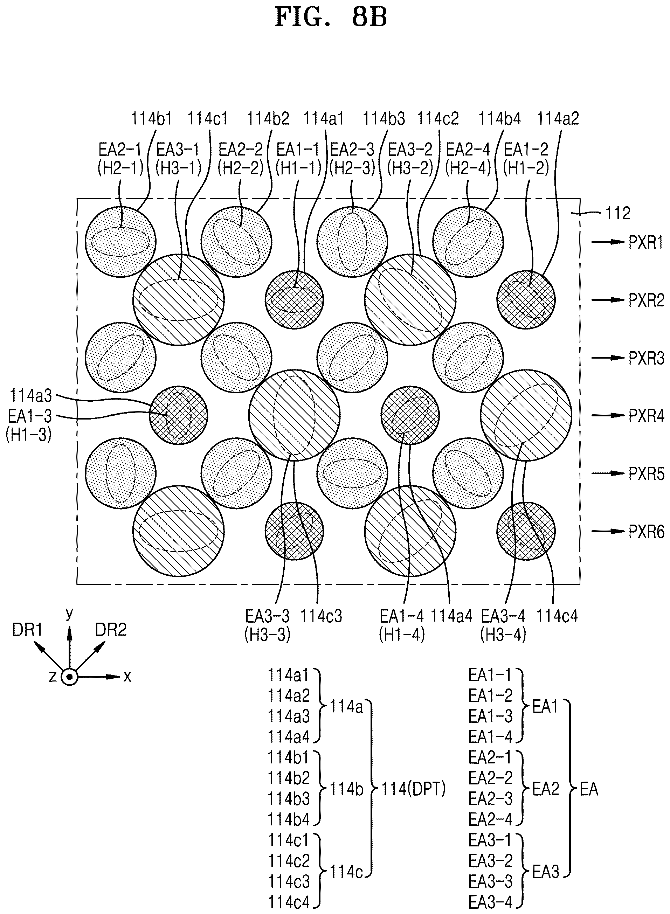

FIG. 8A is a plan view showing a portion of a display panel according to one or more embodiments. FIG. 8B is a plan view showing a portion of a display panel according to one or more embodiments. FIGS. 8A and 8B may be plan views of the display area DA (FIG. 5). FIG. 8A shows the pixel-defining layer 112, and FIG. 8B shows the pixel-defining layer 112 and intermediate layers 114 on the pixel-defining layer 112.

Referring to FIGS. 8A and 8B, the pixel-defining layer 112 may include a plurality of holes defining the plurality of emission areas EA.

In one or more embodiments, first emission areas EA1, second emission areas EA2, and third emission areas EA3 may be defined in the pixel-defining layer 112. For example, each of the first to third emission areas EA1, EA2, and EA3 may be defined by the corresponding hole in the pixel-defining layer 112.

The first emission areas EA1 may include a first-1 emission area EA1-1, a first-2 emission area EA1-2, a first-3 emission area EA1-3, and a first-4 emission area EA1-4. The first-1 emission area EA1-1 may be defined by a first-1 hole H1-1 in the pixel-defining layer 112. The first-2 emission area EA1-2 may be defined by a first-2 hole H1-2 in the pixel-defining layer 112. The first-3 emission area EA1-3 may be defined by a first-3 hole H1-3 in the pixel-defining layer 112. The first-4 emission area EA1-4 may be defined by a first-4 hole H1-4 in the pixel-defining layer 112.

The first emission areas EA1 may have one or more suitable shapes. In one or more embodiments, the first-1 to first-4 emission areas EA1-1, EA1-2, EA1-3, and EA1-4 may each have an elliptical shape. In one or more embodiments, the first-1 emission area EA1-1 may have an elliptical shape with a major axis extending in the x direction. In one or more embodiments, the first-2 emission area EA1-2 may have an elliptical shape with a major axis extending in a first direction DR1. In one or more embodiments, the first-3 emission area EA1-3 may have an elliptical shape with a major axis extending in the y direction. In one or more embodiments, the first-4 emission area EA1-4 may have an elliptical shape with a major axis extending in a second direction DR2.

In one or more embodiments, the first direction DR1 may form an angle of about 45 degrees with a +y direction and may form an angle of about 135 degrees with the +x direction. In one or more embodiments, the second direction DR2 may form an angle of about 45 degrees with the +y direction and may form an angle of about 45 degrees with the +x direction.

In one or more embodiments, the lengths of the major axes of the elliptical shapes of the first-1 to first-4 emission areas EA1-1, EA1-2, EA1-3, and EA1-4 may be the same as one another. In one or more embodiments, the lengths of minor axes of the elliptical shapes of the first-1 to first-4 emission areas EA1-1, EA1-2, EA1-3, and EA1-4 may be the same as one another. For example, the first emission areas EA1 or the first-1 to first-4 emission areas EA1-1, EA1-2, EA1-3, and EA1-4 may have shapes obtained by rotating ellipses with the same dimension at a certain angle (for example, about 45 degrees) based on the aligned centers of the first-1 to first-4 emission areas EA1-1, EA1-2, EA1-3, and EA1-4. For example, the lengths of the major axes of the elliptical shapes of the first-1 to first-4 emission areas EA1-1, EA1-2, EA1-3, and EA1-4 may be the same. Similarly, the lengths of the minor axes of these elliptical shapes may also be the same. For example, the first emission areas EA1 or the first-1 to first-4 emission areas EA1-1, EA1-2, EA1-3, and EA1-4 may have shapes obtained by rotating ellipses of the same dimension at a certain angle (e.g., about 45 degrees) based on the aligned centers of these emission areas.

The second emission areas EA2 may include a second-1 emission area EA2-1, a second-2 emission area EA2-2, a second-3 emission area EA2-3, and a second-4 emission area EA2-4. The second-1 emission area EA2-1 may be defined by a second-1 hole H2-1 in the pixel-defining layer 112. The second-2 emission area EA2-2 may be defined by a second-2 hole H2-2 in the pixel-defining layer 112. The second-3 emission area EA2-3 may be defined by a second-3 hole H2-3 in the pixel-defining layer 112. The second-4 emission area EA2-4 may be defined by a second-4 hole H2-4 in the pixel-defining layer 112.

The second emission areas EA2 may have one or more suitable shapes. In one or more embodiments, the second-1 to second-4 emission areas EA2-1, EA2-2, EA2-3, and EA2-4 may each have an elliptical shape. In one or more embodiments, the second-1 emission area EA2-1 may have an elliptical shape with a major axis extending in the x direction. In one or more embodiments, the second-2 emission area EA2-2 may have an elliptical shape with a major axis extending in the first direction DR1. In one or more embodiments, the second-3 emission area EA2-3 may have an elliptical shape with a major axis extending in the y direction. In one or more embodiments, the second-4 emission area EA2-4 may have an elliptical shape with a major axis extending in the second direction DR2.

In one or more embodiments, the lengths of the major axes of the elliptical shapes of the second-1 to second-4 emission areas EA2-1, EA2-2, EA2-3, and EA2-4 may be the same as one another. In one or more embodiments, the lengths of minor axes of the elliptical shapes of the second-1 to second-4 emission areas EA2-1, EA2-2, EA2-3, and EA2-4 may be the same as one another. For example, the second emission areas EA2 or the second-1 to second-4 emission areas EA2-1, EA2-2, EA2-3, and EA2-4 may have shapes obtained by rotating ellipses with the same dimension at a certain angle (for example, about 45 degrees).

The third emission areas EA3 may include a third-1 emission area EA3-1, a third-2 emission area EA3-2, a third-3 emission area EA3-3, and a third-4 emission area EA3-4. The third-1 emission area EA3-1 may be defined by a third-1 hole H3-1 in the pixel-defining layer 112. The third-2 emission area EA3-2 may be defined by a third-2 hole H3-2 in the pixel-defining layer 112. The third-3 emission area EA3-3 may be defined by a third-3 hole H3-3 in the pixel-defining layer 112. The third-4 emission area EA3-4 may be defined by a third-4 hole H3-4 in the pixel-defining layer 112.

The third emission areas EA3 may have one or more suitable shapes. In one or more embodiments, the third-1 to third-4 emission areas EA3-1, EA3-2, EA3-3, and EA3-4 may each have an elliptical shape. In one or more embodiments, the third-1 emission area EA3-1 may have an elliptical shape with a major axis extending in the x direction. In one or more embodiments, the third-2 emission area EA3-2 may have an elliptical shape with a major axis extending in the first direction DR1. In one or more embodiments, the third-3 emission area EA3-3 may have an elliptical shape with a major axis extending in the y direction. In one or more embodiments, the third-4 emission area EA3-4 may have an elliptical shape with a major axis extending in the second direction DR2.

In one or more embodiments, the lengths of the major axes of the elliptical shapes of the third-1 to third-4 emission areas EA3-1, EA3-2, EA3-3, and EA3-4 may be the same as one another. In one or more embodiments, the lengths of minor axes of the elliptical shapes of the third-1 to third-4 emission areas EA3-1, EA3-2, EA3-3, and EA3-4 may be the same as one another. For example, the third emission areas EA3 or the third-1 to third-4 emission areas EA3-1, EA3-2, EA3-3, and EA3-4 may have shapes obtained by rotating ellipses with the same dimension at a certain angle (for example, about 45 degrees).

In one or more embodiments, the first emission areas EA1 may be red emission areas. For example, the first-1 emission area EA1-1, the first-2 emission area EA1-2, the first-3 emission area EA1-3, and the first-4 emission area EA1-4 may be red emission areas. Therefore, light of the same color may be emitted from the first-1 emission area EA1-1, the first-2 emission area EA1-2, the first-3 emission area EA1-3, and the first-4 emission area EA1-4.

In one or more embodiments, the second emission areas EA2 may be green emission areas. For example, the second-1 emission area EA2-1, the second-2 emission area EA2-2, the second-3 emission area EA2-3, and the second-4 emission area EA2-4 may be green emission areas. Therefore, light of the same color may be emitted from the second-1 emission area EA2-1, the second-2 emission area EA2-2, the second-3 emission area EA2-3, and the second-4 emission area EA2-4. In one or more embodiments, the size of each of the second emission areas EA2, for example, the size of each of the second-1 to second-4 emission areas EA2-1, EA2-2, EA2-3, and EA2-4, may be greater than the size of each of the first emission areas EA1, for example, the size of each of the first-1 to first-4 emission areas EA1-1, EA1-2, EA1-3, and EA1-4.

In one or more embodiments, the third emission areas EA3 may be blue emission areas. For example, the third-1 emission area EA3-1, the third-2 emission area EA3-2, the third-3 emission area EA3-3, and the third-4 emission area EA3-4 may be blue emission areas. Therefore, light of the same color may be emitted from the third-1 emission area EA3-1, the third-2 emission area EA3-2, the third-3 emission area EA3-3, and the third-4 emission area EA3-4. In one or more embodiments, the size of each of the third emission areas EA3, for example, the size of each of the third-1 to third-4 emission areas EA3-1, EA3-2, EA3-3, and EA3-4, may be greater than the size of each of the second emission areas EA2, for example, the size of each of the second-1 to second-4 emission areas EA2-1, EA2-2, EA2-3, and EA2-4.

The intermediate layers 114 may be arranged on the pixel-defining layer 112 and may include first deposition patterns 114a, second deposition patterns 114b, and third deposition patterns 114c.

The first deposition patterns 114a may include a first-1 deposition pattern 114a1, a first-2 deposition pattern 114a2, a first-3 deposition pattern 114a3, and a first-4 deposition pattern 114a4. The first-1 deposition pattern 114a1 may overlap the first-1 emission area EA1-1 and may occupy the first-1 hole H1-1. The first-2 deposition pattern 114a2 may overlap the first-2 emission area EA1-2 and may occupy the first-2 hole H1-2. The first-3 deposition pattern 114a3 may overlap the first-3 emission area EA1-3 and may occupy the first-3 hole H1-3. The first-4 deposition pattern 114a4 may overlap the first-4 emission area EA1-4 and may occupy the first-4 hole H1-4. Areas where the first-1 to first-4 deposition patterns 114a1, 114a2, 114a3, and 114a4 respectively overlap the first-1 to first-4 holes H1-1, H1-2, H1-3, and H1-4 may be where actual light emission occurs. The sizes of the first deposition patterns 114a may be greater than the sizes of the corresponding first emission areas EA1. Accordingly, a portion (for example, a portion that does not overlap the corresponding first emission area EA1) of the first deposition pattern 114a may be arranged on the top surface of the pixel-defining layer 112 as described above with reference to FIG. 7.

In one or more embodiments, the first deposition patterns 114a, for example, the first-1 to first-4 deposition patterns 114a1, 114a2, 114a3, and 114a4, may have the same shape and the same dimension. In one or more embodiments, the first deposition patterns 114a, for example, the first-1 to first-4 deposition patterns 114a1, 114a2, 114a3, and 114a4, may each have a circular shape as shown in FIG. 8B. The disclosure is not necessarily limited thereto, and the first deposition patterns 114a may each have another shape such as an elliptical shape or a polygonal shape.

The shapes of the first deposition patterns 114a may be determined as follows. First, a first shape may be obtained by overlapping the first-1 to first-4 emission areas EA1-1, EA1-2, EA1-3, and EA1-4 with one another or by overlapping the first-1 to first-4 holes H1-1, H1-2, H1-3, and H1-4 with one another (by aligning their centers). In one or more embodiments, the first shape may be obtained by drawing an outline (or an edge) (or an edge area) of the overlapped first-1 to first-4 emission areas EA1-1, EA1-2, EA1-3, and EA1-4 or the overlapped first-1 to first-4 holes H1-1, H1-2, H1-3, and H1-4. Next, the first deposition patterns 114a may each be arranged to have a second shape corresponding to the first shape. The second shape may be sufficiently or relatively larger than the first shape to secure a process margin. In one or more embodiments, the second shape may be geometrically the same as the first shape, but with larger dimensions. In one or more embodiments, the second shape may be any shape that may sufficiently or relatively cover the first shape. For example, the second shape may be a circular shape or an elliptical shape that may sufficiently or substantially cover the first shape. FIG. 8B shows one or more embodiments in which the second shape, for example, the shape of each of the first deposition patterns 114a, is circular.

Accordingly, the first emission areas EA1 (for example, the first-1 to first-4 emission areas EA1-1, EA1-2, EA1-3, and EA1-4) may have different shapes from one another, whereas the corresponding first deposition patterns 114a (for example, the first-1 to first-4 deposition patterns 114a1, 114a2, 114a3, and 114a4) may have the same shape. This may simplify a process of arranging the first deposition patterns 114a as described in more detail.

The process margin, for example, if (e.g., when) described with respect to the first-1 deposition pattern 114a1 and the first-1 emission area EA1-1, may correspond to a dimensional difference between an x-directional edge of the ellipse of the first-1 emission area EA1-1 and an x-directional edge of the first-1 deposition pattern 114a1. In some embodiments, if (e.g., when) described with respect to the first-3 deposition pattern 114a3 and the first-3 emission area EA1-3, the process margin may correspond to a dimensional difference between a y-directional edge of the ellipse of the first-3 emission area EA1-3 and a y-directional edge of the first-3 deposition pattern 114a3.

As such, by arranging the first deposition patterns 114a (for example, the first-1 to first-4 deposition patterns 114a1, 114a2, 114a3, and 114a4) to have a shape (for example, the second shape) corresponding to a shape (for example, the first shape) obtained by overlapping the first emission areas EA1 (for example, the first-1 to first-4 emission areas EA1-1, EA1-2, EA1-3, and EA1-4) with one another, all the first emission areas EA1 may be covered utilizing the first deposition patterns 114a having the same shape and simultaneously a process margin desired or required for all the first emission areas EA1 may be secured.

For example, by arranging the first deposition patterns 114a (e.g., the first-1 to first-4 deposition patterns 114a1, 114a2, 114a3, and 114a4) to have a shape (e.g., the second shape) corresponding to a shape (e.g., the first shape) obtained by overlapping the first emission areas EA1 (e.g., the first-1 to first-4 emission areas EA1-1, EA1-2, EA1-3, and EA1-4), all the first emission areas EA1 are covered utilizing the first deposition patterns 114a with the same shape. This arrangement ensures that the process margin required for all the first emission areas EA1 is secured.

The features of the first deposition patterns 114a may be similarly applied to the second deposition patterns 114b and the third deposition patterns 114c.

The second deposition patterns 114b may include a second-1 deposition pattern 114b1, a second-2 deposition pattern 114b2, a second-3 deposition pattern 114b3, and a second-4 deposition pattern 114b4. The second-1 deposition pattern 114b1 may overlap the second-1 emission area EA2-1 and may occupy the second-1 hole H2-1. The second-2 deposition pattern 114b2 may overlap the second-2 emission area EA2-2 and may occupy the second-2 hole H2-2. The second-3 deposition pattern 114b3 may overlap the second-3 emission area EA2-3 and may occupy the second-3 hole H2-3. The second-4 deposition pattern 114b4 may overlap the second-4 emission area EA2-4 and may occupy the second-4 hole H2-4. Areas where the second-1 to second-4 deposition patterns 114b1, 114b2, 114b3, and 114b4 respectively overlap the second-1 to second-4 holes H2-1, H2-2, H2-3, and H2-4 may be where actual light emission occurs. The sizes of the second deposition patterns 114b may be greater than the sizes of the corresponding second emission areas EA2. Accordingly, a portion (for example, a portion that does not overlap the corresponding second emission area EA2) of the second deposition pattern 114b may be arranged on the top surface of the pixel-defining layer 112 as described above with reference to FIG. 7.

In one or more embodiments, the second deposition patterns 114b, for example, the second-1 to second-4 deposition patterns 114b1, 114b2, 114b3, and 114b4, may have same shape and same dimension. In one or more embodiments, the second deposition patterns 114b, for example, the second-1 to second-4 deposition patterns 114b1, 114b2, 114b3, and 114b4, may each have a circular shape as shown in FIG. 8B. The disclosure is not necessarily limited thereto, and the second deposition patterns 114b may each have another shape such as an elliptical shape or a polygonal shape.

The shapes of the second deposition patterns 114b may be determined as follows. First, a first shape may be obtained by overlapping the second-1 to second-4 emission areas EA2-1, EA2-2, EA2-3, and EA2-4 with one another or by overlapping the second-1 to second-4 holes H2-1, H2-2, H2-3, and H2-4 with one another (by aligning their centers). In one or more embodiments, the first shape may be obtained by drawing an outline (or an edge) (or an edge area) of the overlapped second-1 to second-4 emission areas EA2-1, EA2-2, EA2-3, and EA2-4 or the overlapped second-1 to second-4 holes H2-1, H2-2, H2-3, and H2-4. Next, the second deposition patterns 114b may each be arranged to have a second shape corresponding to the first shape. The second shape may be sufficiently or relatively larger than the first shape to secure a process margin. In one or more embodiments, the second shape may be geometrically the same as the first shape, but with larger dimensions. In one or more embodiments, the second shape may be any shape that may sufficiently or substantially cover the first shape. For example, the second shape may be a circular or elliptical shape that may sufficiently or substantially cover the first shape. FIG. 8B shows one or more embodiments in which the second shape, that is, the shape of each of the second deposition patterns 114b, is circular.

Accordingly, the second emission areas EA2 (for example, the second-1 to second-4 emission areas EA2-1, EA2-2, EA2-3, and EA2-4) may have different shapes from one another, whereas the corresponding second deposition patterns 114b (for example, the second-1 to second-4 deposition patterns 114b1, 114b2, 114b3, and 114b4) may have the same shape. This may simplify a process of arranging the second deposition patterns 114b as described in more detail .

The process margin, for example, if (e.g., when) described with respect to the second-1 deposition pattern 114b1 and the second-1 emission area EA2-1, may correspond to a dimensional difference between an x-directional edge of the ellipse of the second-1 emission area EA2-1 and an x-directional edge of the second-1 deposition pattern 114b1. As another example, if (e.g., when) described with respect to the second-3 deposition pattern 114b3 and the second-3 emission area EA2-3, the process margin may correspond to a dimensional difference between a y-directional edge of the ellipse of the second-3 emission area EA2-3 and a y-directional edge of the second-3 deposition pattern 114b3.

As such, by arranging the second deposition patterns 114b (for example, the second-1 to second-4 deposition patterns 114b1, 114b2, 114b3, and 114b4) to have a shape (for example, the second shape) corresponding to a shape (for example, the first shape) obtained by overlapping the second emission areas EA2 (for example, the second-1 to second-4 emission areas EA2-1, EA2-2, EA2-3, and EA2-4) with one another, all the second emission areas EA2 may be covered utilizing the second deposition patterns 114b having the same shape and simultaneously a process margin desired or required for all the second emission areas EA2 may be secured. For example, this arrangement ensures that the process margin required for all the second emission areas EA2 is secured.

The third deposition patterns 114c may include a third-1 deposition pattern 114c1, a third-2 deposition pattern 114c2, a third-3 deposition pattern 114c3, and a third-4 deposition pattern 114c4. The third-1 deposition pattern 114c1 may overlap the third-1 emission area EA3-1 and may occupy the third-1 hole H3-1. The third-2 deposition pattern 114c2 may overlap the third-2 emission area EA3-2 and may occupy the third-2 hole H3-2. The third-3 deposition pattern 114c3 may overlap the third-3 emission area EA3-3 and may occupy the third-3 hole H3-3. The third-4 deposition pattern 114c4 may overlap the third-4 emission area EA3-4 and may occupy the third-4 hole H3-4. Areas where the third-1 to third-4 deposition patterns 114c1, 114c2, 114c3, and 114c4 respectively overlap the third-1 to third-4 holes H3-1, H3-2, H3-3, and H3-4 may be where actual light emission occurs. The sizes of the third deposition patterns 114c may be greater than the sizes of the third emission areas EA3. Accordingly, a portion (for example, a portion that does not overlap the corresponding third emission area EA3) of the third deposition pattern 114c may be arranged on the top surface of the pixel-defining layer 112 as described above with reference to FIG. 7.

In one or more embodiments, the third deposition patterns 114c, for example, the third-1 to third-4 deposition patterns 114c1, 114c2, 114c3, and 114c4, may have the same shape and the same dimension. In one or more embodiments, the third deposition patterns 114c, for example, the third-1 to third-4 deposition patterns 114c1, 114c2, 114c3, and 114c4, may each have a circular shape as shown in FIG. 8B. The disclosure is not necessarily limited thereto, and the third deposition patterns 114c may each have another shape such as an elliptical or polygonal shape.

The shapes of the third deposition patterns 114c may be determined as follows. First, a first shape may be obtained by overlapping the third-1 to third-4 emission areas EA3-1, EA3-2, EA3-3, and EA3-4 with one another or by overlapping the third-1 to third-4 holes H3-1, H3-2, H3-3, and H3-4 with one another (by aligning their centers). In one or more embodiments, the first shape may be obtained by drawing an outline (or an edge) (or an edge area) of the overlapped third-1 to third-4 emission areas EA3-1, EA3-2, EA3-3, and EA3-4 or the overlapped third-1 to third-4 holes H3-1, H3-2, H3-3, and H3-4. Next, the third deposition patterns 114c may each be arranged to have a second shape corresponding to the first shape. The second shape may be sufficiently or relatively larger than the first shape to secure a process margin. In one or more embodiments, the second shape may be geometrically the same as the first shape, but with larger dimensions. In one or more embodiments, the second shape may be any shape that may sufficiently or substantially cover the first shape. For example, the second shape may be a circular or elliptical shape that may sufficiently or substantially cover the first shape. FIG. 8B shows one or more embodiments in which the second shape, that is, the shape of each of the third deposition patterns 114c, is circular.

Accordingly, the third emission areas EA3 (for example, the third-1 to third-4 emission areas EA3-1, EA3-2, EA3-3, and EA3-4) may have different shapes from one another, whereas the corresponding third deposition patterns 114c (for example, the third-1 to third-4 deposition patterns 114c1, 114c2, 114c3, and 114c4) may have the same shape. This may simplify a process of arranging the third deposition patterns 114c as described in more detail .

The process margin, for example, if (e.g., when) described with respect to the third-1 deposition pattern 114c1 and the third-1 emission area EA3-1, may correspond to a dimensional difference between an x-directional edge of the ellipse of the third-1 emission area EA3-1 and an x-directional edge of the third-1 deposition pattern 114c1. As another example, if (e.g., when) described with respect to the third-3 deposition pattern 114c3 and the third-3 emission area EA3-3, the process margin may correspond to a dimensional difference between a y-directional edge of the ellipse of the third-3 emission area EA3-3 and a y-directional edge of the third-3 deposition pattern 114c3.

As such, by arranging the third deposition patterns 114c (for example, the third-1 to third-4 deposition patterns 114c1, 114c2, 114c3, and 114c4) to have a shape (for example, the second shape) corresponding to a shape (for example, the first shape) obtained by overlapping the third emission areas EA3 (for example, the third-1 to third-4 emission areas EA3-1, EA3-2, EA3-3, and EA3-4) with one another, all the first emission areas EA1 may be covered utilizing the third deposition patterns 114c having the same shape and concurrently (e.g., simultaneously) a process margin desired or required for all the third emission areas EA3 may be secured.

FIG. 8B shows one or more embodiments in which the first deposition patterns 114a, the second deposition patterns 114b, and the third deposition patterns 114c are spaced and/or apart (e.g., spaced apart or separated) from one another, but the disclosure is not necessarily limited thereto. In one or more embodiments, adjacent portions of the first deposition patterns 114a, the second deposition patterns 114b, and the third deposition patterns 114c may overlap one another.

Hereinafter, the arrangement of each of the emission areas EA and the intermediate layers 114 is described. Because deposition patterns DPT of the intermediate layers 114 may overlap the corresponding emission areas EA, the arrangement of the emission areas EA is mainly described in the present specification.

In one or more embodiments, the second emission areas EA2 may be arranged in odd-numbered pixel rows (for example, a first pixel row PXR1, a third pixel row PXR3, and a fifth pixel row PXR5), and the first emission areas EA1 and the third emission areas EA3 may be alternately arranged in even-numbered pixel rows (for example, a second pixel row PXR2, a fourth pixel row PXR4, and a sixth pixel row PXR6). In one or more embodiments, the types (kinds) of the second emission areas EA2 to be arranged in the odd-numbered pixel rows (for example, the first pixel row PXR1, the third pixel row PXR3, and the fifth pixel row PXR5) may vary. In one or more embodiments, the types (kinds) of the first emission areas EA1 and the third emission areas EA3 to be arranged in the even-numbered pixel rows (for example, the second pixel row PXR2, the fourth pixel row PXR4, and the sixth pixel row PXR6) may vary.

In one or more embodiments, the second-1 emission area EA2-1, the second-2 emission area EA2-2, the second-3 emission area EA2-3, and the second-4 emission area EA2-4 may be arranged in the x direction in the first pixel row PXR1. In one or more embodiments, the third-1 emission area EA3-1, the first-1 emission area EA1-1, the third-2 emission area EA3-2, and the first-2 emission area EA1-2 may be arranged in the x direction in the second pixel row PXR2. In one or more embodiments, the second-4 emission area EA2-4, the second-2 emission area EA2-2, the second-4 emission area EA2-4, and the second-4 emission area EA2-4 may be arranged in the x direction in the third pixel row PXR3. In one or more embodiments, the first-3 emission area EA1-3, the third-3 emission area EA3-3, the first-4 emission area EA1-4, and the third-4 emission area EA3-4 may be arranged in the x direction in the fourth pixel row PXR4. In one or more embodiments, the second-3 emission area EA2-3, the second-4 emission area EA2-4, the second-1 emission area EA2-1, and the second-2 emission area EA2-2 may be arranged in the x direction in the fifth pixel row PXR5. In one or more embodiments, the third-1 emission area EA3-1, the first-4 emission area EA1-4, the third-4 emission area EA3-4, and the first-2 emission area EA1-2 may be arranged in the x direction in the sixth pixel row PXR6.

In one or more embodiments, each of the rows of the emission areas EA aligned in the x direction may not be aligned with one another if (e.g., when) viewed in the y direction. For example, centers of the emission areas EA arranged in the odd-numbered pixel rows (for example, the first pixel row PXR1, the third pixel row PXR3, and the fifth pixel row PXR5) and centers of the emission areas EA arranged in the even-numbered pixel rows (for example, the second pixel row PXR2, the fourth pixel row PXR4, and the sixth pixel row PXR6) may not overlap one another if (e.g., when) viewed in the y direction. In one or more embodiments, each of columns of the emission areas EA aligned in the y direction may not be aligned with one another if (e.g., when) viewed in the x direction. In one or more embodiments, the emission areas EA may be aligned in the first direction DR1 and concurrently (e.g., simultaneously) aligned in the second direction DR2.

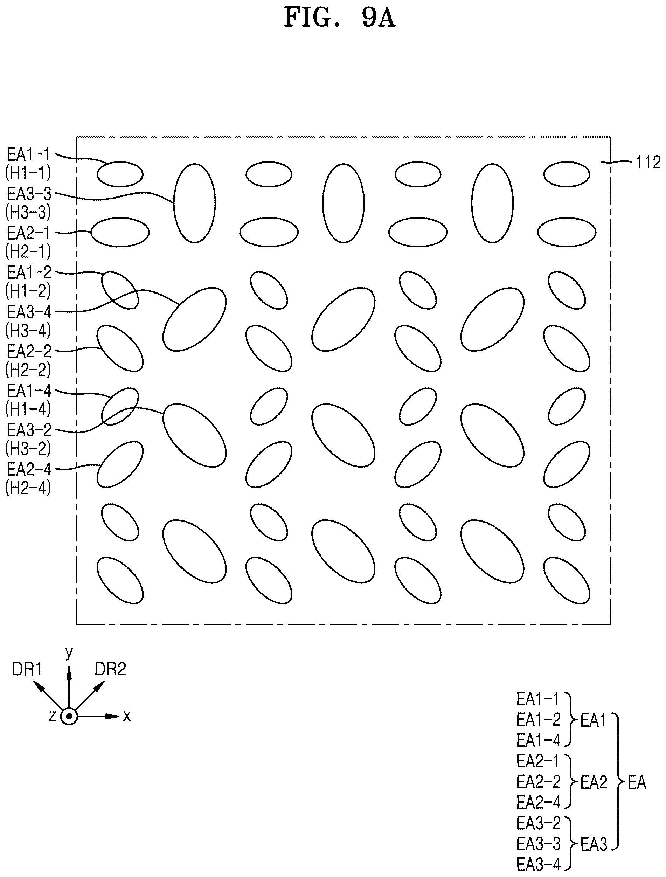

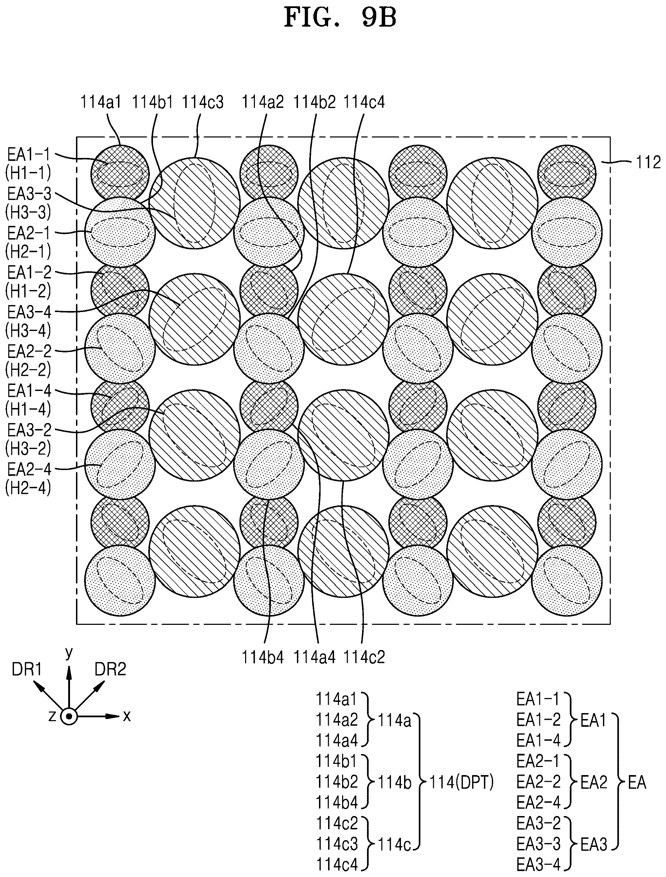

FIG. 9A is a plan view showing a portion of a display panel according to one or more embodiments. FIG. 9B is a plan view showing a portion of a display panel according to one or more embodiments. FIGS. 9A and 9B may be plan views of the display area DA (FIG. 5). FIG. 9A shows the pixel-defining layer 112, and FIG. 9B shows the pixel-defining layer 112 and the intermediate layers 114 on the pixel-defining layer 112.

Referring to FIGS. 9A and 9B, the first emission areas EA1 may include the first-1 emission area EA1-1, the first-2 emission area EA1-2, and the first-4 emission area EA1-4. The second emission areas EA2 may include the second-1 emission area EA2-1, the second-2 emission area EA2-2, and the second-4 emission area EA2-4. The third emission areas EA3 may include the third-1 emission area EA3-1, the third-2 emission area EA3-2, and the third-4 emission area EA3-4. The pixel-defining layer 112 may include the first-1 hole H1-1 corresponding to the first-1 emission area EA1-1, the first-2 hole H1-2 corresponding to the first-2 emission area EA1-2, the first-4 hole H1-4 corresponding to the first-4 emission area EA1-4, the second-1 hole H2-1 corresponding to the second-1 emission area EA2-1, the second-2 hole H2-2 corresponding to the second-2 emission area EA2-2, the second-4 hole H2-4 corresponding to the second-4 emission area EA2-4, the third-1 hole H3-1 corresponding to the third-1 emission area EA3-1, the third-2 hole H3-2 corresponding to the third-2 emission area EA3-2, and the third-4 hole H3-4 corresponding to the third-4 emission area EA3-4.

The first deposition patterns 114a may include the first-1 deposition pattern 114a1, the first-2 deposition pattern 114a2, and the first-4 deposition pattern 114a4. The second deposition patterns 114b may include the second-1 deposition pattern 114b1, the second-2 deposition pattern 114b2, and the second-4 deposition pattern 114b4. The third deposition patterns 114c may include the third-1 deposition pattern 114c1, the third-2 deposition pattern 114c2, and the third-4 deposition pattern 114c4.

The relationship between the first emission areas EA1 and the first deposition patterns 114a, the relationship between the second emission areas EA2 and the second deposition patterns 114b, and the relationship between the third emission areas EA3 and the third deposition patterns 114c are as described above with reference to FIGS. 8A and 8B.

In one or more embodiments, the first deposition patterns 114a may overlap the adjacent second deposition patterns 114b. FIG. 9B shows one or more embodiments in which the second deposition patterns 114b are arranged on the first deposition patterns 114a in areas where the first deposition patterns 114a and the second deposition patterns 114b overlap one another, but the disclosure is not necessarily limited thereto, and the vertical arrangement may be reversed.

In one or more embodiments, the second deposition patterns 114b may overlap the adjacent third deposition patterns 114c. FIG. 9B shows one or more embodiments in which the third deposition patterns 114c are arranged on the second deposition patterns 114b in areas where the second deposition patterns 114b and the third deposition patterns 114c overlap one another, but the disclosure is not necessarily limited thereto, and the vertical arrangement may be reversed.

One of the first emission areas EA1, one of the second emission areas EA2, and one of the third emission areas EA3 may be grouped together.

In one or more embodiments, the first-1 emission area EA1-1, the second-1 emission area EA2-1, and the third-3 emission area EA3-3 may be grouped together. In the group, the first-1 emission area EA1-1 may be arranged in the y direction relative to the second-1 emission area EA2-1, and the third-3 emission area EA3-3 may be arranged in the x direction relative to the first-1 emission area EA1-1 and the second-1 emission area EA2-1. Groups of the first-1 emission area EA1-1, the second-1 emission area EA2-1, and the third-3 emission area EA3-3 may be arranged in the x direction.

In one or more embodiments, the first-2 emission area EA1-2, the second-2 emission area EA2-2, and the third-4 emission area EA3-4 may be grouped together. In the group, the first-2 emission area EA1-2 may be arranged in the y direction relative to the second-2 emission area EA2-2, and the third-4 emission area EA3-4 may be arranged in the x direction relative to the first-2 emission area EA1-2 and the second-2 emission area EA2-2. Groups of the first-2 emission area EA1-2, the second-2 emission area EA2-2, and the third-4 emission area EA3-4 may be arranged in the x direction.

In one or more embodiments, the first-4 emission area EA1-4, the second-4 emission area EA2-4, and the third-2 emission area EA3-2 may be grouped together. In the group, the first-4 emission area EA1-4 may be arranged in the y direction relative to the second-4 emission area EA2-4, and the third-2 emission area EA3-2 may be arranged in the x direction relative to the first-4 emission area EA1-4 and the second-4 emission area EA2-4. Groups of the first-4 emission area EA1-4, the second-4 emission area EA2-4, and the third-2 emission area EA3-2 may be arranged in the x direction.

In one or more embodiments, the first-2 emission area EA1-2, the second-2 emission area EA2-2, and the third-2 emission area EA3-2 may be grouped together. In the group, the first-2 emission area EA1-2 may be arranged in the y direction relative to the second-2 emission area EA2-2, and the third-2 emission area EA3-2 may be arranged in the x direction relative to the first-2 emission area EA1-2 and the second-2 emission area EA2-2. Groups of the first-2 emission area EA1-2, the second-2 emission area EA2-2, and the third-2 emission area EA3-2 may be arranged in the x direction.

In one or more embodiments, different groups may be arranged in the x direction, unlike shown in FIGS. 9A and 9B.

In one or more embodiments, the first emission areas EA1 may be aligned in the x direction. In one or more embodiments, the second emission areas EA2 may be aligned in the x direction. In one or more embodiments, the first emission areas EA1 and the second emission areas EA2 may be aligned in the y direction. In one or more embodiments, the third emission areas EA3 may be aligned in the x direction and the y direction.

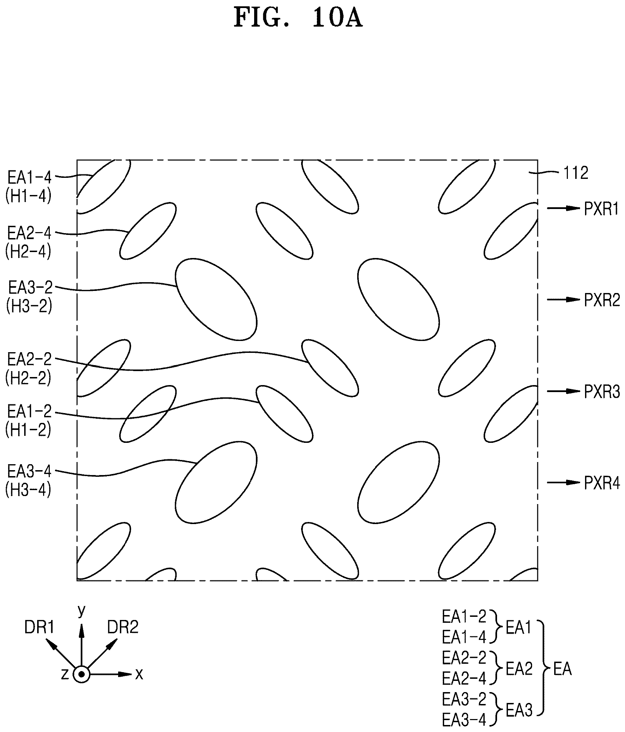

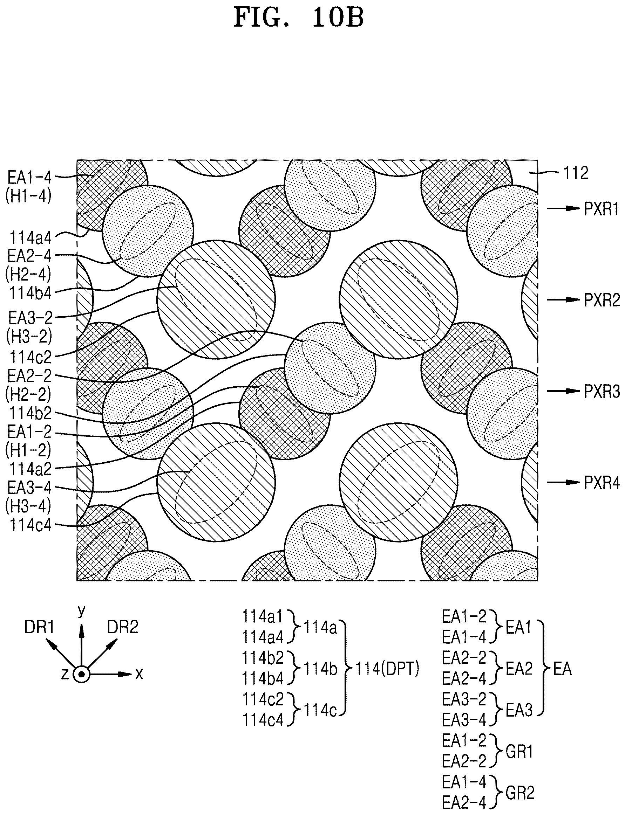

FIG. 10A is a plan view showing a portion of a display panel according to one or more embodiments. FIG. 10B is a plan view showing a portion of a display panel according to one or more embodiments. FIGS. 10A and 10B may be plan views of the display area DA (FIG. 5). FIG. 10A shows the pixel-defining layer 112, and FIG. 10B shows the pixel-defining layer 112 and the intermediate layers 114 on the pixel-defining layer 112.

Referring to FIGS. 10A and 10B, the first emission areas EA1 may include the first-2 emission area EA1-2 and the first-4 emission area EA1-4. The second emission areas EA2 may include the second-2 emission area EA2-2 and the second-4 emission area EA2-4. The third emission areas EA3 may include the third-2 emission area EA3-2 and the third-4 emission area EA3-4. The pixel-defining layer 112 may include the first-2 hole H1-2 corresponding to the first-2 emission area EA1-2, the first-4 hole H1-4 corresponding to the first-4 emission area EA1-4, the second-2 hole H2-2 corresponding to the second-2 emission area EA2-2, the second-4 hole H2-4 corresponding to the second-4 emission area EA2-4, the third-2 hole H3-2 corresponding to the third-2 emission area EA3-2, and the third-4 hole H3-4 corresponding to the third-4 emission area EA3-4.

The first deposition patterns 114a may include the first-2 deposition pattern 114a2 and the first-4 deposition pattern 114a4. The second deposition patterns 114b may include the second-2 deposition pattern 114b2 and the second-4 deposition pattern 114b4. The third deposition patterns 114c may include the third-2 deposition pattern 114c2 and the third-4 deposition pattern 114c4.

The relationship between the first emission areas EA1 and the first deposition patterns 114a, the relationship between the second emission areas EA2 and the second deposition patterns 114b, and the relationship between the third emission areas EA3 and the third deposition patterns 114c are as described above with reference to FIGS. 8A and 8B.

In one or more embodiments, the first deposition patterns 114a may overlap the adjacent second deposition patterns 114b. FIG. 10B shows one or more embodiments in which the second deposition patterns 114b are arranged on the first deposition patterns 114a in areas where the first deposition patterns 114a and the second deposition patterns 114b overlap one another, but the disclosure is not necessarily limited thereto, and the vertical arrangement may be reversed.

In one or more embodiments, the second deposition patterns 114b may overlap the adjacent third deposition patterns 114c. FIG. 10B shows one or more embodiments in which the third deposition patterns 114c are arranged on the second deposition patterns 114b in areas where the second deposition patterns 114b and the third deposition patterns 114c overlap one another, but the disclosure is not necessarily limited thereto, and the vertical arrangement may be reversed.

In one or more embodiments, the third deposition patterns 114c may overlap the adjacent first deposition patterns 114a. FIG. 10B shows one or more embodiments in which the third deposition patterns 114c are arranged on the first deposition patterns 114a in areas where the third deposition patterns 114c and the first deposition patterns 114a overlap one another, but the disclosure is not necessarily limited thereto, and the vertical arrangement may be reversed.

One of the first emission areas EA1 and one of the second emission areas EA2 may be grouped together.

In one or more embodiments, the first-2 emission area EA1-2 and the second-2 emission area EA2-2 may be grouped into a first group GR1, and the second-2 emission area EA2-2 may be arranged in the second direction DR2 relative to the first-2 emission area EA1-2. In one or more embodiments, the first-4 emission area EA1-4 and the second-4 emission area EA2-4 may be grouped into a second group GR2, and the first-4 emission area EA1-4 may be arranged in the first direction DR1 relative to the second-4 emission area EA2-4.

In one or more embodiments, the first group GR1 and the second group GR2 may be alternately arranged in the x direction in the first and third pixel rows PXR1 and PXR3. In one or more embodiments, the third-2 emission areas EA3-2 may be arranged in the x direction in the second pixel row PXR2. In one or more embodiments, the third-4 emission areas EA3-4 may be arranged in the x direction in the fourth pixel row PXR4.

In one or more embodiments, the first groups GR1 may be arranged and aligned in the y direction. In one or more embodiments, the second groups GR2 may be arranged and aligned in the y direction. In one or more embodiments, the third-2 emission area EA3-2 and the third-4 emission area EA3-4 may be alternately arranged in the y direction and may be aligned with one another.

In one or more embodiments, the second group GR2, the third-4 emission area EA3-4, the first group GR1, and the third-2 emission area EA3-2 may be arranged in the first direction DR1. In one or more embodiments, the second group GR2, the third-2 emission area EA3-2, the first group GR1, and the third-4 emission area EA3-4 may be arranged in the first direction DR1.

In one or more embodiments, the second group GR2, the third-4 emission area EA3-4, the first group GR1, and the third-2 emission area EA3-2 may be arranged in the second direction DR2. In one or more embodiments, the second group GR2, the third-2 emission area EA3-2, the first group GR1, and the third-4 emission area EA3-4 may be arranged in the second direction DR2.

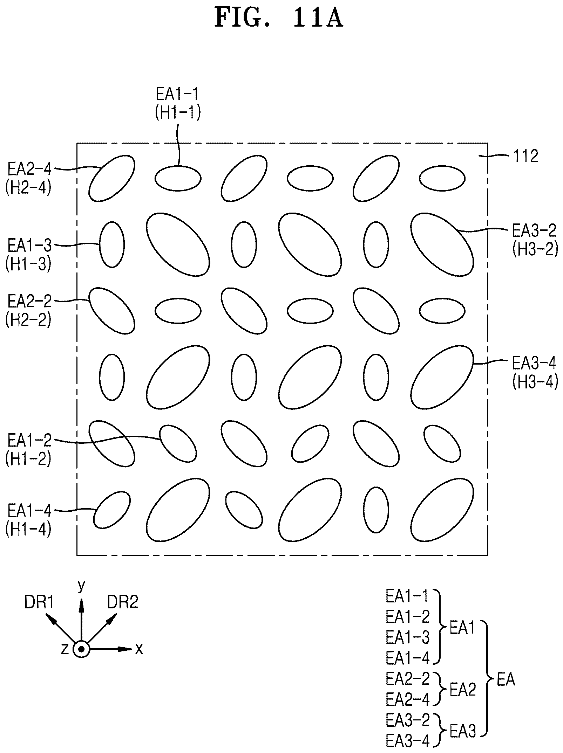

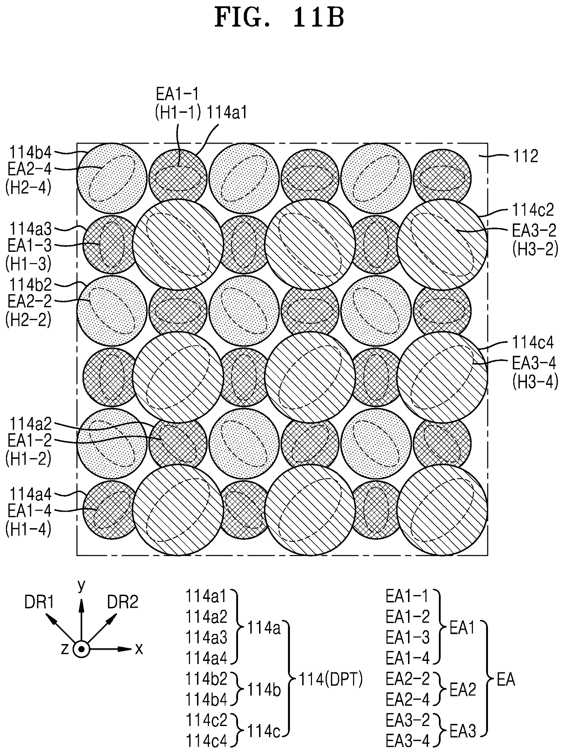

FIG. 11A is a plan view showing a portion of a display panel according to one or more embodiments. FIG. 11B is a plan view showing a portion of a display panel according to one or more embodiments. FIGS. 11A and 11B may be plan views of the display area DA (FIG. 5). FIG. 11A shows the pixel-defining layer 112, and FIG. 11B shows the pixel-defining layer 112 and the intermediate layers 114 on the pixel-defining layer 112.

Referring to FIGS. 11A and 11B, the first emission areas EA1 may include the first-1 emission area EA1-1, the first-2 emission area EA1-2, the first-3 emission area EA1-3, and the first-4 emission area EA1-4. The second emission areas EA2 may include the second-2 emission area EA2-2 and the second-4 emission area EA2-4. The third emission areas EA3 may include the third-2 emission area EA3-2 and the third-4 emission area EA3-4. The pixel-defining layer 112 may include the first-1 hole H1-1 corresponding to the first-1 emission area EA1-1, the first-2 hole H1-2 corresponding to the first-2 emission area EA1-2, the first-3 hole H1-3 corresponding to the first-3 emission area EA1-3, the first-4 hole H1-4 corresponding to the first-4 emission area EA1-4, the second-2 hole H2-2 corresponding to the second-2 emission area EA2-2, the second-4 hole H2-4 corresponding to the second-4 emission area EA2-4, the third-2 hole H3-2 corresponding to the third-2 emission area EA3-2, and the third-4 hole H3-4 corresponding to the third-4 emission area EA3-4.

The first deposition patterns 114a may include the first-1 deposition pattern 114a1, the first-2 deposition pattern 114a2, the first-3 deposition pattern 114a3, and the first-4 deposition pattern 114a4. The second deposition patterns 114b may include the second-2 deposition pattern 114b2 and the second-4 deposition pattern 114b4. The third deposition patterns 114c may include the third-2 deposition pattern 114c2 and the third-4 deposition pattern 114c4.

The relationship between the first emission areas EA1 and the first deposition patterns 114a, the relationship between the second emission areas EA2 and the second deposition patterns 114b, and the relationship between the third emission areas EA3 and the third deposition patterns 114c are as described above with reference to FIGS. 8A and 8B.

In one or more embodiments, the third deposition patterns 114c may overlap the adjacent first deposition patterns 114a. FIG. 11B shows one or more embodiments in which the third deposition patterns 114c are arranged on the first deposition patterns 114a in areas where the third deposition patterns 114c and the first deposition patterns 114a overlap one another, but the disclosure is not necessarily limited thereto, and the vertical arrangement may be reversed.

FIG. 11B shows that the first deposition patterns 114a and the second deposition patterns 114b do not overlap one another, but the disclosure is not necessarily limited thereto.

Two of the first emission areas EA1, one of the second emission areas EA2, and one of the third emission areas EA3 may be grouped together.

In one or more embodiments, the first-1 emission area EA1-1, the first-3 emission area EA1-3, the second-4 emission area EA2-4, and the third-2 emission area EA3-2 may be grouped together. In the group, the first-1 emission area EA1-1 may be arranged in the +x direction relative to the second-4 emission area EA2-4 and the +y direction relative to the third-2 emission area EA3-2. In the group, the second-4 emission area EA2-4 may be arranged in the -x direction relative to the first-1 emission area EA1-1 and the +y direction relative to the first-3 emission area EA1-3. In the group, the first-3 emission area EA1-3 may be arranged in the -x direction relative to the third-2 emission area EA3-2 and a -y direction relative to the second-4 emission area EA2-4. In the group, the third-2 emission area EA3-2 may be arranged in the +x direction relative to the first-3 emission area EA1-3 and the -y direction relative to the first-1 emission area EA1-1. Groups of the first-1 emission area EA1-1, the first-3 emission area EA1-3, the second-4 emission area EA2-4, and the third-2 emission area EA3-2 may be arranged in the x direction.

In one or more embodiments, the first-1 emission area EA1-1, the first-3 emission area EA1-3, the second-2 emission area EA2-2, and the third-4 emission area EA3-4 may be grouped together. In the group, the first-1 emission area EA1-1 may be arranged in the +x direction relative to the second-2 emission area EA2-2 and the +y direction relative to the third-4 emission area EA3-4. In the group, the second-2 emission area EA2-2 may be arranged in the -x direction relative to the first-1 emission area EA1-1 and the +y direction relative to the first-3 emission area EA1-3. In the group, the first-3 emission area EA1-3 may be arranged in the -x direction relative to the third-4 emission area EA3-4 and the -y direction relative to the second-2 emission area EA2-2. In the group, the third-4 emission area EA3-4 may be arranged in the +x direction relative to the first-3 emission area EA1-3 and the -y direction relative to the first-1 emission area EA1-1. Groups of the first-1 emission area EA1-1, the first-3 emission area EA1-3, the second-2 emission area EA2-2, and the third-4 emission area EA3-4 may be arranged in the x direction.

In one or more embodiments, the first-2 emission area EA1-2, the first-4 emission area EA1-4, the second-2 emission area EA2-2, and the third-2 emission area EA3-2 may be grouped together. In the group, the first-2 emission area EA1-2 may be arranged in the +x direction relative to the second-2 emission area EA2-2 and the +y direction relative to the third-2 emission area EA3-2. In the group, the second-2 emission area EA2-2 may be arranged in the -x direction relative to the first-2 emission area EA1-2 and the +y direction relative to the first-4 emission area EA1-4. In the group, the first-4 emission area EA1-4 may be arranged in the -x direction relative to the third-2 emission area EA3-2 and the -y direction relative to the second-2 emission area EA2-2. In the group, the third-2 emission area EA3-2 may be arranged in the +x direction relative to the first-4 emission area EA1-4 and the -y direction relative to the first-2 emission area EA1-2. Groups of the first-2 emission area EA1-2, the first-4 emission area EA1-4, the second-2 emission area EA2-2, and the third-2 emission area EA3-2 may be arranged in the x direction.

In one or more embodiments, different groups may be arranged in the x direction, unlike shown in FIGS. 11A and 11B.

In one or more embodiments, the first emission areas EA1 and the second emission areas EA2 may be alternately arranged in the x direction. In one or more embodiments, the first emission areas EA1 and the second emission areas EA2 may be alternately arranged in the y direction. In one or more embodiments, the first emission areas EA1 and the third emission areas EA3 may be alternately arranged in the x direction. In one or more embodiments, the first emission areas EA1 and the third emission areas EA3 may be alternately arranged in the y direction.

Hereinbefore, one or more embodiments in which the shapes of the emission areas EA of the pixel-defining layer 112 are elliptical has been shown and mainly described, but the disclosure is not necessarily limited to one or more embodiments in which the emission areas have elliptical shapes. In addition, one or more embodiments of the arrangement of the emission areas EA and the intermediate layers 114 are merely examples and do not limit the disclosure.

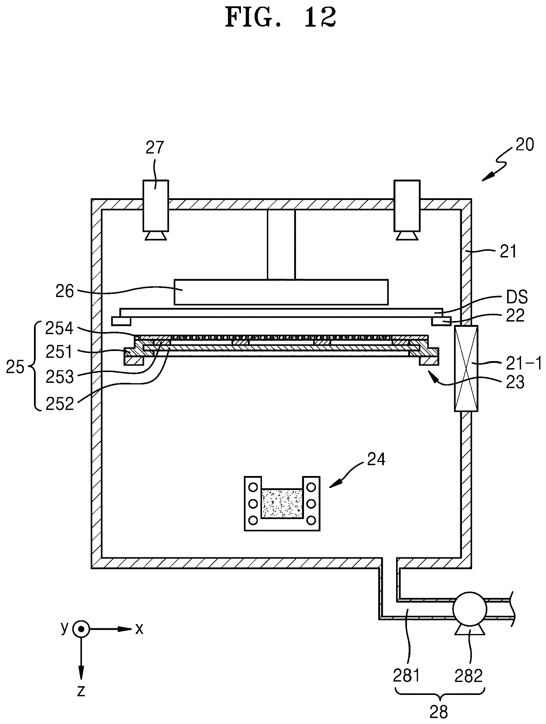

Hereinafter, a method and apparatus that may be utilized to form the deposition patterns DPT (for example, the first to third deposition patterns 114a, 114b, and 114c) of the intermediate layers 114 having the above-described features are described with reference to FIGS. 12 to 16D.

FIG. 12 is a cross-sectional view showing a display panel manufacturing apparatus according to one or more embodiments.

Referring to FIG. 12, a display panel manufacturing apparatus 20 may include a chamber 21, a first support 22, a second support 23, a deposition source 24, a deposition mask 25, a magnetic force unit 26, a vision unit 27, and a pressure control unit 28.

A display substrate DS may be an aspect to be processed or applied by the display panel manufacturing apparatus 20. Referring back to FIG. 7 in conjunction with FIG. 12, the display substrate DS may be a semi-finished product during a process of manufacturing the display panel 11. In one or more embodiments, the display substrate DS may be a semi-finished product in a state where the pixel-defining layer 112 among the components of the display panel 11 has been formed. In one or more embodiments, FIGS. 8A, 9A, 10A, and 11A may be plan views of the display substrate DS. In one or more embodiments, FIGS. 8B, 9B, 10B, and 11B may be plan views of the display substrate DS after a process utilizing the display panel manufacturing apparatus 20 described in more detail . In one or more embodiments, the display panel manufacturing apparatus 20 may be a deposition apparatus (for example, which arranges the intermediate layer 114 on the display substrate DS). In one or more embodiments, a display panel manufacturing method may include a deposition process (for example, which arranges the intermediate layer 114 on the display substrate DS). The disclosure is not limited to being utilized only for the deposition of the intermediate layer 114, and the display panel manufacturing apparatus 20 and the manufacturing method may be utilized in one or more suitable deposition processes. In one or more embodiments, one display substrate DS does not necessarily correspond to one display panel 11, and a plurality of display panels 11 may be manufactured utilizing one display substrate DS. In one or more embodiments, a plurality of display panels 11 may be obtained by cutting one display substrate DS.

The chamber 21 may have a space formed therein and may have an open portion. In this case, a gate valve 21-1 may be installed in the open portion of the chamber 21. The open portion of the chamber 21 may be open or closed according to the operation of the gate valve 21-1.

The display substrate DS may be placed on and supported by the first support 22. In one or more embodiments, the first support 22 may be in the form of a plate fixed inside the chamber 21. In one or more embodiments, the first support 22 may be where the display substrate DS is placed and may be in the form of a shuttle capable of linear motion inside the chamber 21. In one or more embodiments, the first support 22 may include an electrostatic chuck or an adhesive chuck, which is arranged in the chamber 21, so as to be fixed to the chamber 21 or to be able to move up and down inside the chamber 21. Hereinafter, for convenience of explanation, a case where the first support 22 is in the form of a plate fixed inside the chamber 21 is mainly described.

The deposition mask 25 may be placed on the second support 23. In this case, the second support 23 may be arranged inside the chamber 21. The second support 23 may precisely adjust a position of the deposition mask 25. In one or more embodiments, the second support 23 may include a separate driving unit or an alignment unit to move the deposition mask 25 in different directions. In one or more embodiments, the second support 23 may be in the form of a shuttle. In this case, the second support 23 may be where the deposition mask 25 is placed and may transfer the deposition mask 25. For example, the second support 23 may be moved to outside the chamber 21 and may enter the chamber 21 from outside the chamber 21 after the deposition mask 25 is placed thereon.

The first support 22 and the second support 23 may be integrally formed as a single body. In this case, the first support 22 and the second support 23 may each include a movable shuttle. In this case, the first support 22 and the second support 23 may each include a structure that fixes the deposition mask 25 and the display substrate DS while the display substrate DS is placed on the deposition mask 25, and may linearly move the display substrate DS and the deposition mask 25 at the same time.

Hereinafter, for convenience of explanation, a case where the first support 22 and the second support 23 are separately formed at different positions inside the chamber 21 is mainly described.

The deposition source 24 may be arranged inside the chamber 21 to face the deposition mask 25. In this case, the deposition source 24 may accommodate a deposition material, and by applying heat to the deposition material, the deposition material may evaporate or sublimate. The deposition source 24 may be fixed inside the chamber 21 or may be arranged inside the chamber 21 so as to be capable of linear motion in one direction. Hereinafter, for convenience of explanation, a case where the deposition source 24 is fixed inside the chamber 21 is mainly described. FIG. 12 shows that the deposition source 24 is arranged under the deposition source 24, but in one or more embodiments, the deposition source 24 may be arranged above the display substrate DS and may spray a deposition material downward. For example, FIG. 12 shows a +z direction as the direction of gravity, but in one or more embodiments, the +z direction may be the opposite to the direction of gravity.

The deposition mask 25 may include a mask frame 251, first and second support sticks 252 and 253, and a tension sheet 254.

The magnetic force unit 26 may be arranged inside the chamber 21 to face the display substrate DS. In this case, the magnetic force unit 26 may apply a magnetic force to the tension sheet 254 and press the deposition mask 25 toward the display substrate DS. In particular, the magnetic force unit 26 may not only prevent or reduce sagging of the tension sheet 254, but also allow the tension sheet 254 to be in close contact with the display substrate DS. In addition, the magnetic force unit 26 may uniformly (e.g., substantially uniformly) maintain a gap between the tension sheet 254 and the display substrate DS with respect to a longitudinal direction of the tension sheet 254.

The vision unit 27 may be installed in the chamber 21 and may capture images of positions of the display substrate DS and the deposition mask 25. In this case, the vision unit 27 may include a camera that captures images of the display substrate DS and the deposition mask 25. The positions of the display substrate DS and the deposition mask 25 may be identified based on the images captured by the vision unit 27, and based on the images, the first support 22 may precisely adjust the position of the display substrate DS or the second support 23 may precisely adjust the position of the deposition mask 25. Hereinafter, a case where the second support 23 precisely adjusts the position of the deposition mask 25 to align the positions of the display substrate DS and the deposition mask 25 is mainly described in more detail.

The pressure control unit 28 may be connected to the chamber 21 and control pressure inside the chamber 21. For example, the pressure control unit 28 may control the pressure inside the chamber 21 to be the same as or similar to atmospheric pressure. In addition, the pressure control unit 28 may control the pressure inside the chamber 21 to be the same as or similar to a vacuum state.

The pressure control unit 28 may include a connection pipe 281 connected to the chamber 21 and a pump 282 installed on the connection pipe 281. According to the operation of the pump 282, external air may be introduced through the connection pipe 281, or gas inside the chamber 21 may be guided to the outside through the connection pipe 281.

Hereinafter, one or more embodiments of the operation of the display panel manufacturing apparatus 20 is described.

First, if (e.g., when) the pressure control unit 28 makes the inside of the chamber 21 have pressure the same as or similar to atmospheric pressure, the gate valve 21-1 may operate to open the open portion of the chamber 21.

Hereinafter, the display substrate DS may be loaded from outside the chamber 21 into the chamber 21. The display substrate DS may be loaded into the chamber 21 in one or more suitable manners. In one or more embodiments, the display substrate DS may be loaded from outside the chamber 21 into the chamber 21 by a robot arm arranged outside the chamber 21. In one or more embodiments, if (e.g., when) the first support 22 is formed to have a shuttle shape, the first support 22 may be carried out from inside of the chamber 21 to outside of the chamber 21, and then, the display substrate DS may be placed on the first support 22 by a separate robot arm arranged outside the chamber 21, and the first support 22 may be loaded from outside the chamber 21 into the chamber 21. Hereinafter, for convenience of explanation, a case where the display substrate DS is loaded from outside the chamber 21 into the chamber 21 by the robot arm arranged outside the chamber 21 is mainly described.

The deposition mask 25 may be arranged inside the chamber 21. In one or more embodiments, the deposition mask 25 may be loaded from outside the chamber 21 into the chamber 21 in substantially the same or similar manner as the display substrate DS. Hereinafter, for convenience of explanation, a case where only the display substrate DS is loaded from outside the chamber 21 into the chamber 21 while the deposition mask 25 is arranged inside the chamber 21 is mainly described.

In one or more embodiments, it is also possible that the first support 22 and the second support 23 are each in the form of a shuttle and are each loaded from outside the chamber 21 into the chamber 21 after the display substrate DS and the deposition mask 25 are fixed.

If (e.g., when) the display substrate DS is loaded into the chamber 21, the display substrate DS may be placed on the first support 22. The vision unit 27 may capture images of positions of the display substrate DS and the deposition mask 25. For example, the vision unit 27 may capture images of a first alignment mark of the display substrate DS and a second alignment mark of the deposition mask 25.

The positions of the display substrate DS and the deposition mask 25 may be identified based on the captured first and second alignment marks. In this case, the display panel manufacturing apparatus 20 includes a separate control unit to identify the positions of the display substrate DS and the deposition mask 25.

If (e.g., when) the positions of the display substrate DS and the deposition mask 25 are identified, the second support 23 may precisely adjust the position of the deposition mask 25 to align the display substrate DS and the deposition mask 25.

Afterwards, the deposition source 24 may operate to spray a deposition material toward the deposition mask 25 (for example, in a -z direction), and the deposition material that has passed through an opening (for example, a plurality of openings in the tension sheet 254) in the deposition mask 25 may be arranged (for example, deposited) on the display substrate DS.

In one or more embodiments, the pump 282 sucks in gas from inside the chamber 21 and discharges the gas to the outside, allowing pressure inside the chamber 21 to be maintained the same as or similar to a vacuum.

The operation as described above may be repeated on a plurality of display substrates DS. In one or more embodiments, if (e.g., when) the number of depositions on the plurality of display substrates DS reaches a preset number, the operation of the display panel manufacturing apparatus 20 may be stopped, and the deposition mask 25 may be withdrawn to the outside of the chamber 21.

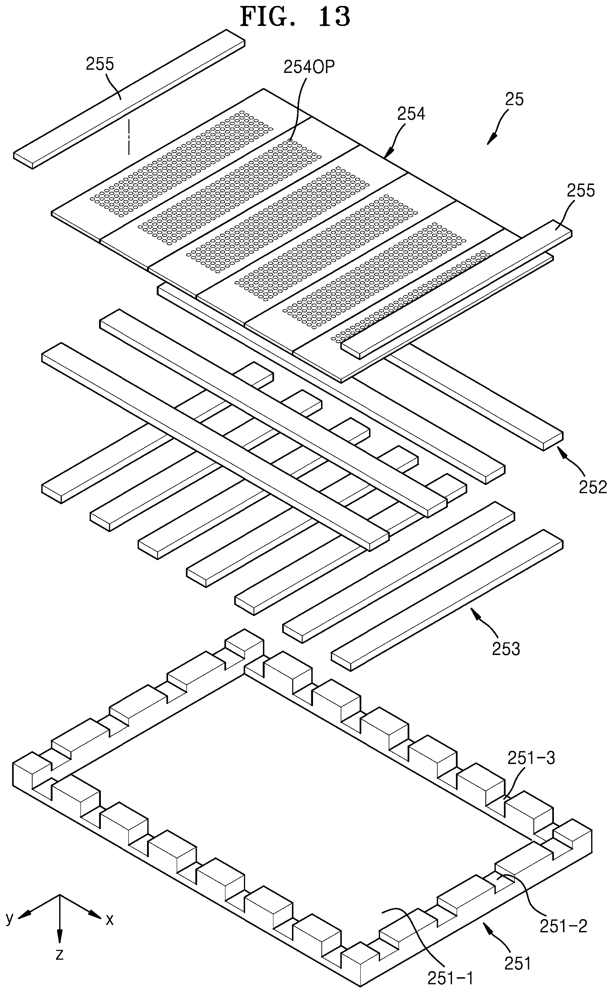

FIG. 13 is an exploded perspective view showing a deposition mask according to one or more embodiments.

Referring to FIG. 13, the deposition mask 25 may include the mask frame 251, the first and second support sticks 252 and 253, and the tension sheet 254.

The mask frame 251 may have a plurality of frames connected to one another to form a space therein. In one or more embodiments, the mask frame 251 may be in the form of a picture frame with one opening 251-1 formed in the center thereof. In one or more embodiments, the mask frame 251 may be in the form of a grid, such as a window frame, including an opening. Hereinafter, for convenience of explanation, a case where the mask frame 251 includes one opening 251-1 in the center thereof is mainly described. The length of one side (or long side) of the mask frame 251 may be greater than the length of the other side (or short side) thereof. In one or more embodiments, one side of the mask frame 251, extending in the x direction, may be defined as the long side of the mask frame 251, and one side of the mask frame 251, extending in the y direction, may be defined as the short side of the mask frame 251. The length of the long side of the mask frame 251 may be greater than the length of the short side of the mask frame 251. The disclosure is not limited thereto, and in one or more embodiments, the long side of the mask frame 251 may extend in the y direction, and the short side of the mask frame 251 may extend in the x direction.

The mask frame 251 may include a first groove 251-2 and a second groove 251-3, which are formed in one surface (for example, in the -z direction). The first and second grooves 251-2 and 251-3 may not pass through the mask frame 251 in the z direction and may be arranged at certain intervals. For example, the first groove 251-2 is provided as a plurality, and the plurality of first grooves 251-2 may be spatially connected to the opening 251-1 in the mask frame 251 and may be arranged in the y direction. Similarly, the second groove 251-3 is provided as a plurality, and the plurality of second grooves 251-3 may be spatially connected to the opening 251-1 in the mask frame 251 and may be arranged in the x direction. The first and second grooves 251-2 and 251-3 may provide spaces for insertion of both (e.g., opposite) ends of the first and second support sticks 252 and 253, respectively, allowing the first and second support sticks 252 and 253 to be fixed to the mask frame 251. The first groove 251-2 may pass through the mask frame 251 in the x direction. The second groove 251-3 may pass through the mask frame 251 in the y direction.

The first and second support sticks 252 and 253 may be arranged on the mask frame 251. In this case, the first support stick 252 and the second support stick 253 may each be provided as a plurality, and the plurality of first support sticks 252 and the plurality of second support sticks 253 may each be spaced and/or apart (e.g., spaced apart or separated) from one another. For example, the plurality of first support sticks 252 and the plurality of second support sticks 253 may be arranged parallel to one side and spaced and/or apart (e.g., spaced apart or separated) from one another. In one or more embodiments, the first support sticks 252 may extend in the x direction and may be arranged in the y direction. The first support sticks 252 may be parallel to the long side of the mask frame 251. The second support sticks 253 may extend in the y direction and may be arranged in the x direction. The second support sticks 253 may be parallel to the short side of the mask frame 251. In one or more embodiments, the first support sticks 252 may not be provided, and only the second support sticks 253 may be arranged on the mask frame 251. In one or more embodiments, the second support sticks 253 may not be provided, and only the first support sticks 252 may be arranged on the mask frame 251.

In one or more embodiments, the first support stick 252 may have both (e.g., opposite) ends inserted into the first groove 251-2 and thus may be fixed to the mask frame 251, and the second support stick 253 may have both (e.g., opposite) ends inserted into the second groove 251-3 and thus may be fixed to the mask frame 251. In this case, both (e.g., opposite) side surfaces of the first support stick 252 may be coplanar with both (e.g., opposite) side surfaces of the mask frame 251. For example, a side surface of the first support stick 252, opposite to (e.g., facing) the x direction, may be coplanar with a side surface of the mask frame 251, opposite to (e.g., facing) the x direction. Similarly, both (e.g., opposite) side surfaces of the second support stick 253 may be coplanar with both (e.g., opposite) side surfaces of the mask frame 251. For example, a side surface of the second support stick 253, opposite to (e.g., facing) the y direction, may be coplanar with a side surface of the mask frame 251, opposite to (e.g., facing) the y direction. In one or more embodiments, the first and second grooves 251-2 and 251-3 may not be provided, and the first support stick 252 and/or the second support stick 253 may be arranged (for example, welded) directly on a top surface of the mask frame 251, opposite to (e.g., facing) the -z direction. FIG. 13 shows four first support sticks 252 and seven second support sticks 253, but the disclosure is not necessarily limited to specific numbers of the first and second support sticks 252 and 253.

The tension sheet 254 may be provided as at least one. If (e.g., when) the tension sheet 254 is provided as at least two, the at least two tension sheets 254 may each have a shape extending in one direction (for example, the y direction) and may be arranged in another direction (for example, the x direction). In this case, one side of each of the at least two tension sheets 254, extending in the y direction, may be understood as a long side of the tension sheet 254, and one side of each of the at least two tension sheets 254, extending in the x direction, may be understood as a short side of the tension sheet 254. In one or more embodiments, the first support stick 252 extending in the x direction may cross a plurality of tension sheets 254, and the second support stick 253 extending in the y direction may overlap two adjacent tension sheets 254 at the same time.

The tension sheet 254 may include at least one opening 254OP. For example, the tension sheet 254 may have a plurality of openings 254OP formed therein. In one or more embodiments, the plurality of openings 254OP in the tension sheet 254 may have the same shape. For example, the plurality of openings 254OP in the tension sheet 254 may have the same geometric shape and the same size. The plurality of openings 254OP may be spaced and/or apart (e.g., spaced apart or separated) from one another at certain intervals in one direction (for example, the x direction or the y direction) and may pass through the tension sheet 254. In one or more embodiments, some of the openings 254OP in the tension sheet 254 may overlap the first support stick 252. In one or more embodiments, the openings 254OP in the tension sheet 254 may be arranged not to overlap the first support stick 252. For example, the openings 254OP may not be arranged in portions of the tension sheet 254, overlapping the first support stick 252.

The tension sheet 254 may be coupled onto the mask frame 251. For example, the tension sheet 254 may be welded onto the top surface (or a surface opposite to (e.g., facing) the -z direction) of the mask frame 251. Tension sheets 254 may be in contact with one another or may be spaced and/or apart (e.g., spaced apart or separated) from one another. If (e.g., when) the tension sheets 254 are spaced and/or apart (e.g., spaced apart or separated) from one another, a portion of the second support stick 253 may be exposed in a gap between the tension sheets 254.

An alignment stick 255 may be arranged on one side of the outermost tension sheet 254. In one or more embodiments, the alignment stick 255 extending in the y direction may be arranged on a +x side of the outermost tension sheet 254 arranged in the +x direction among a plurality of tension sheets 254. In addition, the alignment stick 255 extending in the y direction may also be arranged on a -x side of the outermost tension sheet 254 arranged in the -x direction among the plurality of tension sheets 254. The alignment stick 255 may be in contact with or spaced and/or apart (e.g., spaced apart or separated) from the tension sheet 254. The alignment stick 255 may act as the second alignment mark of the deposition mask 25, as described with reference to FIG. 12.

Referring back to FIG. 12 in conjunction with FIG. 13, a deposition material sprayed toward the deposition mask 25 and the display substrate DS by the deposition source 24 may be arranged (for example, deposited) on the display substrate DS by passing through the opening 251-1 in the mask frame 251 and the plurality of openings 254OP in the tension sheet 254. The deposition material that is arranged (for example, deposited) on the display substrate DS by passing through the plurality of openings 254OP in the tension sheet 254 may correspond to the deposition patterns DPT of the intermediate layers 114 described above with reference to FIGS. 8A to 11B.

In this case, the shapes of the deposition patterns DPT may be determined by the openings 254OP in the tension sheet 254. For example, the deposition patterns DPT may have the same shape as the openings 254OP in the tension sheet 254. For example, the shapes of the deposition patterns DPT arranged on the display substrate DS (for example, arranged on the pixel-defining layer 112 (see FIG. 7)) may be controlled or selected through design of the shapes of the openings 254OP in the tension sheet 254.

Referring back to FIGS. 8A and 8B in conjunction with FIG. 13, because the deposition mask 25 may be utilized to arrange the deposition patterns DPT of the intermediate layers 114 on the plurality of emission areas EA, positions of the plurality of openings 254OP in the tension sheet 254 of the deposition mask 25 may be aligned with positions of the plurality of emission areas EA (or positions of the plurality of holes in the pixel-defining layer 112). Therefore, one or more suitable tension sheets 254 with arrangements of the openings 254OP corresponding to one or more suitable arrangements of the emission areas EA described with reference to FIGS. 8A to 11B may be provided and utilized.

In one or more embodiments, one deposition mask 25 (for example, a first mask) may be utilized to implement the first deposition patterns 114a corresponding to the first emission areas EA1, another deposition mask 25 (for example, a second mask) may be utilized to implement the second deposition patterns 114b corresponding to the second emission areas EA2, and another deposition mask 25 (for example, a third mask) may be utilized to implement the third deposition patterns 114c corresponding to the third emission areas EA3. The shape of the first deposition patterns 114a may correspond to the shape of the openings 254OP in the tension sheet 254 of the first mask. The shape of the second deposition patterns 114b may correspond to the shape of the openings 254OP in the tension sheet 254 of the second mask. The shape of the third deposition patterns 114c may correspond to the shape of the openings 254OP in the tension sheet 254 of the third mask. In one or more embodiments, the openings 254OP in the tension sheet 254 of the first mask, the openings 254OP in the tension sheet 254 of the second mask, and the openings 254OP in the tension sheet 254 of the third mask may have the same geometric shape (for example, a circle) and different sizes (for example, diameters) from one another. In one or more embodiments, the openings 254OP in the tension sheet 254 of the first mask, the openings 254OP in the tension sheet 254 of the second mask, and the openings 254OP in the tension sheet 254 of the third mask may have different geometric shapes from one another and different sizes from one another.

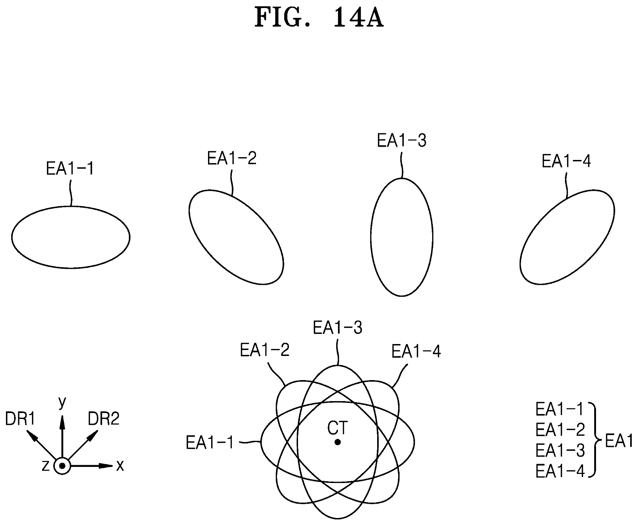

Hereinafter, the shape of an opening 254OP in the tension sheet 254 that may correspond to the shapes of one or more suitable emission areas EA at the same time, and a method of designing the opening 254OP, are described with reference to FIGS. 14A to 16D. Hereinafter, although the first emission area EA1 is utilized as an example, the description of the following embodiments may apply similarly (for example, substantially identical) to the second emission area EA2 and/or the third emission area EA3.

The tension sheet 254 of the deposition mask 25 may have the opening 254OP having a second shape SH2. For example, the opening 254OP having the second shape SH2 may be provided in the tension sheet 254 of the deposition mask 25. For example, the opening 254OP in the tension sheet 254 of the deposition mask 25 may be designed to have the second shape SH2.

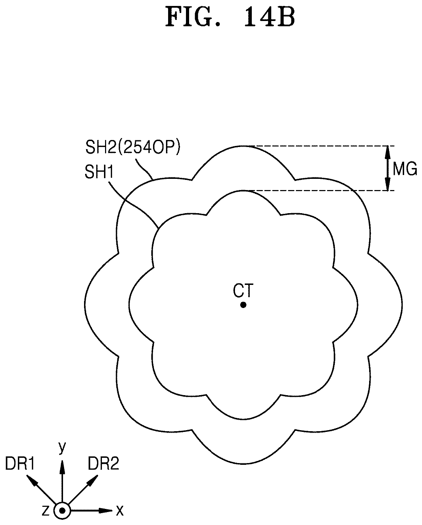

FIG. 14A is a schematic view of emission areas according to one or more embodiments. FIGS. 14B to 14D are schematic views of a first shape and a second shape according to one or more embodiments.

Referring to FIG. 14A, the first emission areas EA1 may include the first-1 to first-4 emission areas EA1-1, EA1-2, EA1-3, and EA1-4. FIG. 14A shows the first-1 to first-4 emission areas EA1-1, EA1-2, EA1-3, and EA1-4 individually, and also shows the first-1 to first-4 emission areas EA1-1, EA1-2, EA1-3, and EA1-4 overlapping one another.

In one or more embodiments, the first-1 to first-4 emission areas EA1-1, EA1-2, EA1-3, and EA1-4 may overlap one another by aligning (for example, matching) their respective centers CT. In one or more embodiments, the first-1 to first-4 emission areas EA1-1, EA1-2, EA1-3, and EA1-4 may overlap one another by spacing their respective centers CT apart. In the present specification, the centers CT of the first emission areas EA1 may refer to centroids of the first emission areas EA1.

In one or more embodiments, the first-1 emission area EA1-1 may have a major axis extending in the x direction and a minor axis extending in the y direction, and may be symmetrical about the major axis and the minor axis. In one or more embodiments, the first-1 emission area EA1-1 may have a shape obtained by rotating the first-4 emission area EA1-4 about 45 degrees in a clockwise direction.

In one or more embodiments, the first-2 emission area EA1-2 may have a major axis extending in the first direction DR1 and a minor axis extending in the second direction DR2, and may be symmetrical about the major axis and the minor axis. In one or more embodiments, the first-2 emission area EA1-2 may have a shape obtained by rotating the first-1 emission area EA1-1 about 45 degrees in the clockwise direction.

In one or more embodiments, the first-3 emission area EA1-3 may have a major axis extending in the y direction and a minor axis extending in the x direction, and may be symmetrical about the major axis and the minor axis. In one or more embodiments, the first-3 emission area EA1-3 may have a shape obtained by rotating the first-2 emission area EA1-2 about 45 degrees in the clockwise direction.

In one or more embodiments, the first-4 emission area EA1-4 may have a major axis extending in the second direction DR2 and a minor axis extending in the first direction DR1, and may be symmetrical about the major axis and the minor axis. In one or more embodiments, the first-4 emission area EA1-4 may have a shape obtained by rotating the first-3 emission area EA1-3 about 45 degrees in the clockwise direction.

Hereinafter, referring to FIGS. 14A to 14D, a first shape SH1 and the second shape SH2 may be obtained by overlapping the first-1 to first-4 emission areas EA1-1, EA1-2, EA1-3, and EA1-4 with one another. In one or more embodiments, the first shape SH1 may be obtained by overlapping the first-1 to first-4 emission areas EA1-1, EA1-2, EA1-3, and EA1-4 with one another.

In one or more embodiments, as shown in FIG. 14B, the first shape SH1 may be obtained by drawing an outermost line of a shape obtained by overlapping the first-1 to first-4 emission areas EA1-1, EA1-2, EA1-3, and EA1-4 with one another, for example, an atomic model shape. In one or more embodiments, the first shape SH1 may be obtained by connecting portions of respective outlines of the first-1 to first-4 emission areas EA1-1, EA1-2, EA1-3, and EA1-4 to one another.

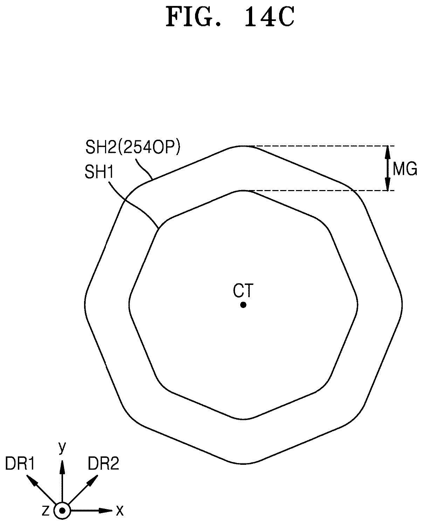

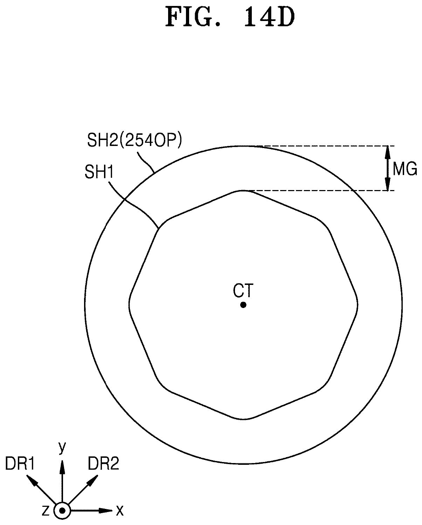

In one or more embodiments, as shown in FIGS. 14C and 14D, the first shape SH1 may be obtained by overlapping the first-1 to first-4 emission areas EA1-1, EA1-2, EA1-3, and EA1-4 with one another, and then arranging a tangent between each of adjacent first emission areas EA1 and drawing an outermost line. Accordingly, the first shape SH1 in FIGS. 14C and 14D may be an octagon with approximately rounded corners.

The size of the second shape SH2 corresponding to the first shape SH1 may be greater than the size of the first shape SH1.

In one or more embodiments, as shown in FIGS. 14B and 14C, the second shape SH2 may be geometrically the same as the first shape SH1 and may have larger dimensions than the first shape SH1. For example, the second shape SH2 may be geometrically the same as the first shape SH1, but may be expanded by a process margin MG in all directions.

In one or more embodiments, as shown in FIG. 14D, the second shape SH2 may be geometrically different from the first shape SH1 and may have larger dimensions than the first shape SH1. For example, the second shape SH2 may be a circle or an ellipse, each expanded by the process margin MG from an outermost edge of the first shape SH1. In this regard, the outermost edge of the first shape SH1 may refer to, for example, rounded corners of the first shape SH1.

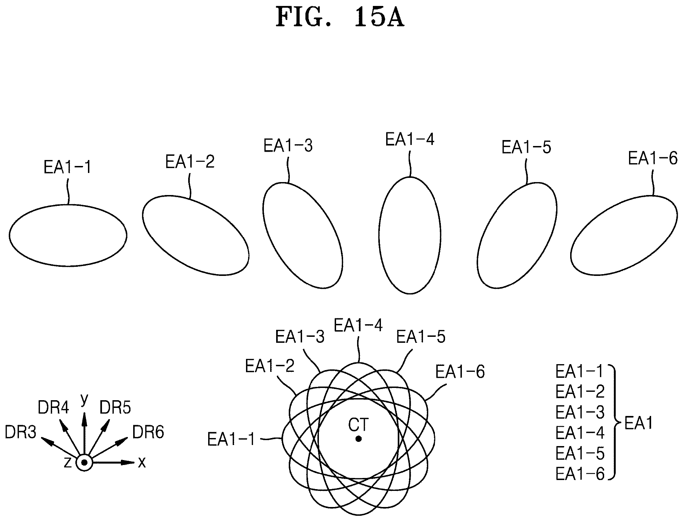

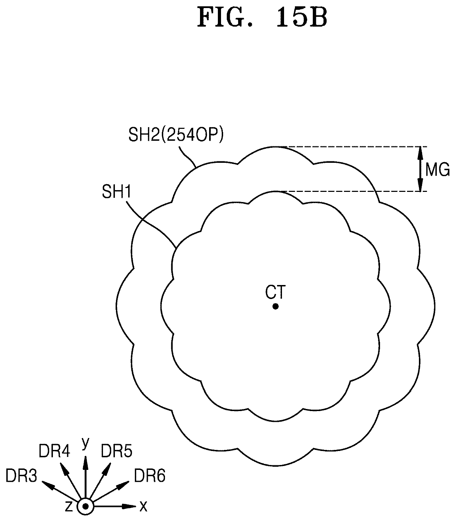

FIG. 15A is a schematic view of emission areas according to one or more embodiments. FIGS. 15B to 15D are schematic views of a first shape and a second shape according to one or more embodiments.

Referring to FIG. 15A, the first emission areas EA1 may include first-1 to first-6 emission areas EA1-1, EA1-2, EA1-3, EA1-4, EA1-5, and EA1-6. FIG. 15A shows the first-1 to first-6 emission areas EA1-1, EA1-2, EA1-3, EA1-4, EA1-5, and EA1-6 individually, and also shows the first-1 to first-6 emission areas EA1-1, EA1-2, EA1-3, EA1-4, EA1-5, and EA1-6 overlapping one another.

In one or more embodiments, the first-1 to first-6 emission areas EA1-1, EA1-2, EA1-3, EA1-4, EA1-5, and EA1-6 may overlap one another by aligning (for example, matching) their respective centers CT. In one or more embodiments, the first-1 to first-6 emission areas EA1-1, EA1-2, EA1-3, EA1-4, EA1-5, and EA1-6 may overlap one another by spacing their respective centers CT apart.

In one or more embodiments, a third direction DR3 may form an angle of about 60 degrees with the +y direction and may form an angle of about 150 degrees with the +x direction. In one or more embodiments, a fourth direction DR4 may form an angle of about 30 degrees with the +y direction and may form an angle of about 120 degrees with the +x direction. In one or more embodiments, a fifth direction DR5 may form an angle of about 30 degrees with the +y direction and may form an angle of about 60 degrees with the +x direction. In one or more embodiments, a sixth direction DR6 may form an angle of about 60 degrees with the +y direction and may form an angle of about 30 degrees with the +x direction. In one or more embodiments, the third direction DR3 and the fifth direction DR5 may be normal (e.g., perpendicular) to each other. In one or more embodiments, the fourth direction DR4 and the sixth direction DR6 may be normal (e.g., perpendicular) to each other.

In one or more embodiments, the first-1 emission area EA1-1 may have a major axis extending in the x direction and a minor axis extending in the y direction, and may be symmetrical about the major axis and the minor axis. In one or more embodiments, the first-1 emission area EA1-1 may have a shape obtained by rotating the first-6 emission area EA1-6 about 30 degrees in a clockwise direction.

In one or more embodiments, the first-2 emission area EA1-2 may have a major axis extending in the third direction DR3 and a minor axis extending in the fifth direction DR5, and may be symmetrical about the major axis and the minor axis. In one or more embodiments, the first-2 emission area EA1-2 may have a shape obtained by rotating the first-1 emission area EA1-1 about 30 degrees in the clockwise direction.

In one or more embodiments, the first-3 emission area EA1-3 may have a major axis extending in the fourth direction DR4 and a minor axis extending in the sixth direction DR6, and may be symmetrical about the major axis and the minor axis. In one or more embodiments, the first-3 emission area EA1-3 may have a shape obtained by rotating the first-2 emission area EA1-2 about 30 degrees in the clockwise direction.

In one or more embodiments, the first-4 emission area EA1-4 may have a major axis extending in the y direction and a minor axis extending in the x direction, and may be symmetrical about the major axis and the minor axis. In one or more embodiments, the first-4 emission area EA1-4 may have a shape obtained by rotating the first-3 emission area EA1-3 about 30 degrees in the clockwise direction.

In one or more embodiments, the first-5 emission area EA1-5 may have a major axis extending in the fifth direction DR5 and a minor axis extending in the third direction DR3, and may be symmetrical about the major axis and the minor axis. In one or more embodiments, the first-5 emission area EA1-5 may have a shape obtained by rotating the first-4 emission area EA1-4 about 30 degrees in the clockwise direction.

In one or more embodiments, the first-6 emission area EA1-6 may have a major axis extending in the sixth direction DR6 and a minor axis extending in the fourth direction DR4, and may be symmetrical about the major axis and the minor axis. In one or more embodiments, the first-6 emission area EA1-6 may have a shape obtained by rotating the first-5 emission area EA1-5 about 30 degrees in the clockwise direction.

Hereinafter, referring to FIGS. 15A to 15D, the first shape SH1 and the second shape SH2 may be obtained by overlapping the first-1 to first-6 emission areas EA1-1, EA1-2, EA1-3, EA1-4, EA1-5, and EA1-6 with one another. In one or more embodiments, the first shape SH1 may be obtained by overlapping the first-1 to first-6 emission areas EA1-1, EA1-2, EA1-3, EA1-4, EA1-5, and EA1-6 with one another.

In one or more embodiments, as shown in FIG. 15B, the first shape SH1 may be obtained by drawing an outermost line of a shape obtained by overlapping the first-1 to first-6 emission areas EA1-1, EA1-2, EA1-3, EA1-4, EA1-5, and EA1-6 with one another, for example, an atomic model shape. In one or more embodiments, the first shape SH1 may be obtained by connecting portions of respective outlines of the first-1 to first-6 emission areas EA1-1, EA1-2, EA1-3, EA1-4, EA1-5, and EA1-6 to one another.

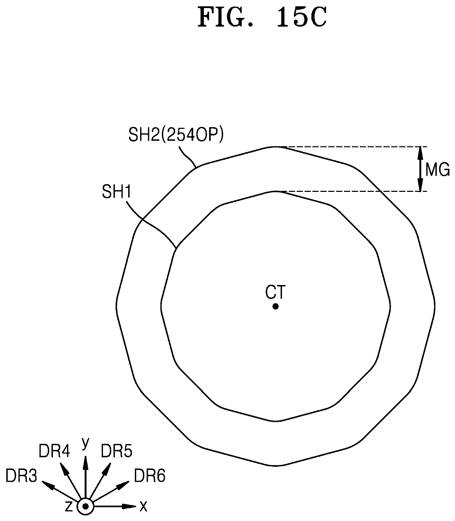

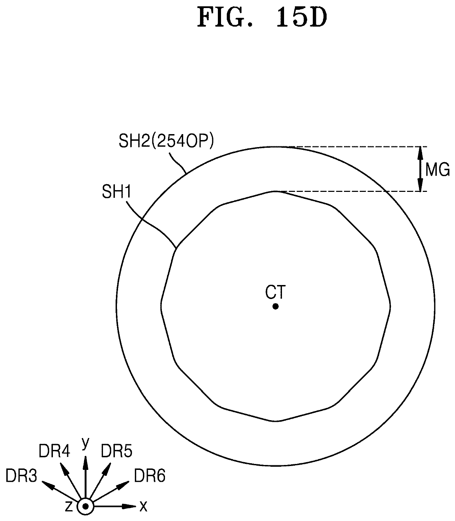

In one or more embodiments, as shown in FIGS. 15C and 15D, the first shape SH1 may be obtained by overlapping the first-1 to first-6 emission areas EA1-1, EA1-2, EA1-3, EA1-4, EA1-5, and EA1-6 with one another, and then arranging a tangent between each of adjacent first emission areas EA1 and drawing an outermost line. Accordingly, the first shape SH1 in FIGS. 15C and 15D may be a dodecagon with approximately rounded corners.

The size of the second shape SH2 corresponding to the first shape SH1 may be greater than the size of the first shape SH1.

In one or more embodiments, as shown in FIGS. 15B and 15C, the second shape SH2 may be geometrically the same as the first shape SH1 and may have larger dimensions than the first shape SH1. For example, the second shape SH2 may be geometrically the same as the first shape SH1, but may be expanded by the process margin MG in all directions.

In one or more embodiments, as shown in FIG. 15D, the second shape SH2 may be geometrically different from the first shape SH1 and may have larger dimensions than the first shape SH1. For example, the second shape SH2 may be a circle or an ellipse, each expanded by the process margin MG from an outermost edge of the first shape SH1. In this regard, the outermost edge of the first shape SH1 may refer to, for example, rounded corners of the first shape SH1.

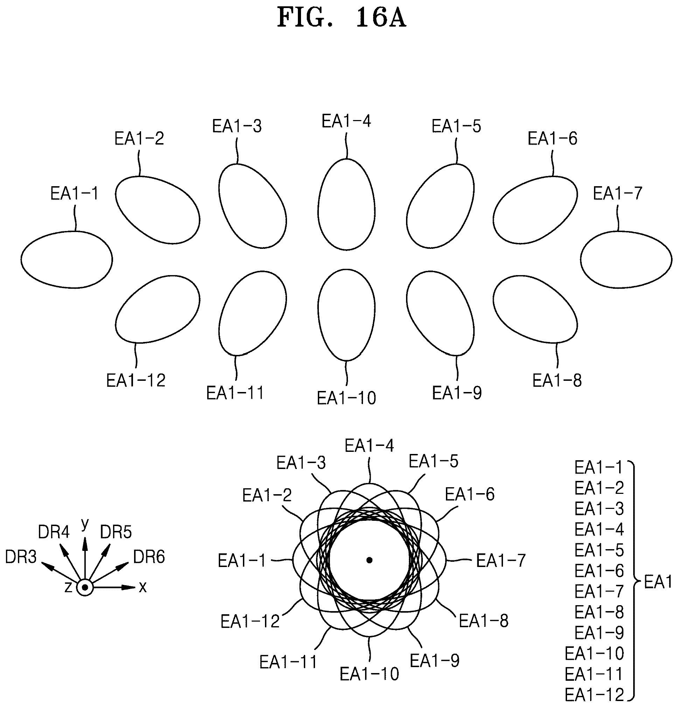

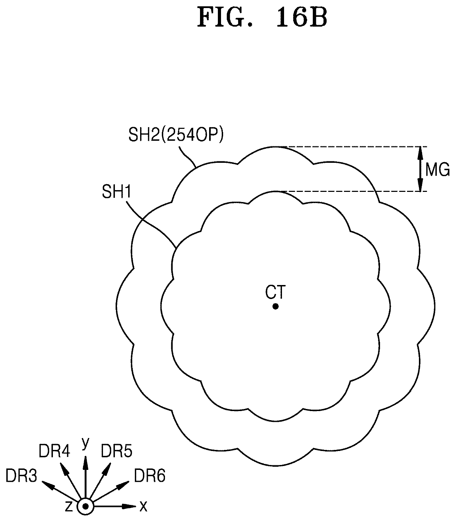

FIG. 16A is a schematic view of emission areas according to one or more embodiments. FIGS. 16B to 16D are schematic views of a first shape and a second shape according to one or more embodiments.

Referring to FIG. 16A, the first emission areas EA1 may include first-1 to first-12 emission areas EA1-1, EA1-2, EA1-3, EA1-4, EA1-5, EA1-6, EA1-7, EA1-8, EA1-9, EA1-10, EA1-11, and EA1-12. FIG. 16A shows the first-1 to first-12 emission areas EA1-1, EA1-2, EA1-3, EA1-4, EA1-5, EA1-6, EA1-7, EA1-8, EA1-9, EA1-10, EA1-11, and EA1-12 individually, and also shows the first-1 to first-12 emission areas EA1-1, EA1-2, EA1-3, EA1-4, EA1-5, EA1-6, EA1-7, EA1-8, EA1-9, EA1-10, EA1-11, and EA1-12 overlapping one another.

In one or more embodiments, the first-1 to first-12 emission areas EA1-1, EA1-2, EA1-3, EA1-4, EA1-5, EA1-6, EA1-7, EA1-8, EA1-9, EA1-10, EA1-11, and EA1-12 may overlap one another by aligning (for example, matching) their respective centers CT. In one or more embodiments, the first-1 to first-12 emission areas EA1-1, EA1-2, EA1-3, EA1-4, EA1-5, EA1-6, EA1-7, EA1-8, EA1-9, EA1-10, EA1-11, and EA1-12 may overlap one another by spacing their respective centers CT apart. As described above, the centers CT may refer to centroids.

In one or more embodiments, the first-1 emission area EA1-1 may have a major axis extending in the x direction and a minor axis extending in the y direction, and may be symmetrical about the major axis and asymmetrical about the minor axis. In one or more embodiments, the first-1 emission area EA1-1 may have an asymmetric elliptical shape having a greater length in the -x direction than in the +x direction with respect to the minor axis. In one or more embodiments, the first-1 emission area EA1-1 may have a shape obtained by rotating the first-12 emission area EA1-12 about 30 degrees in a clockwise direction.

In one or more embodiments, the first-2 emission area EA1-2 may have a major axis extending in the third direction DR3 and a minor axis extending in the fifth direction DR5, and may be symmetrical about the major axis and asymmetrical about the minor axis. In one or more embodiments, the first-2 emission area EA1-2 may have an asymmetric elliptical shape having a greater length in the third direction DR3 than in a direction opposite to the third direction DR3 with respect to the minor axis. In one or more embodiments, the first-2 emission area EA1-2 may have a shape obtained by rotating the first-1 emission area EA1-1 about 30 degrees in the clockwise direction.

In one or more embodiments, the first-3 emission area EA1-3 may have a major axis extending in the fourth direction DR4 and a minor axis extending in the sixth direction DR6, and may be symmetrical about the major axis and asymmetrical about the minor axis. In one or more embodiments, the first-3 emission area EA1-3 may have an asymmetric elliptical shape having a greater length in the fourth direction DR4 than in a direction opposite to the fourth direction DR4 with respect to the minor axis. In one or more embodiments, the first-3 emission area EA1-3 may have a shape obtained by rotating the first-2 emission area EA1-2 about 30 degrees in the clockwise direction.

In one or more embodiments, the first-4 emission area EA1-4 may have a major axis extending in the y direction and a minor axis extending in the x direction, and may be symmetrical about the major axis and asymmetrical about the minor axis. In one or more embodiments, the first-4 emission area EA1-4 may have an asymmetric elliptical shape having a greater length in the +y direction than in the -y direction with respect to the minor axis. In one or more embodiments, the first-4 emission area EA1-4 may have a shape obtained by rotating the first-3 emission area EA1-3 about 30 degrees in the clockwise direction.

In one or more embodiments, the first-5 emission area EA1-5 may have a major axis extending in the fifth direction DR5 and a minor axis extending in the third direction DR3, and may be symmetrical about the major axis and asymmetrical about the minor axis. In one or more embodiments, the first-5 emission area EA1-5 may have an asymmetric elliptical shape having a greater length in the fifth direction DR5 than in a direction opposite to the fifth direction DR5 with respect to the minor axis. In one or more embodiments, the first-5 emission area EA1-5 may have a shape obtained by rotating the first-4 emission area EA1-4 about 30 degrees in the clockwise direction.

In one or more embodiments, the first-6 emission area EA1-6 may have a major axis extending in the sixth direction DR6 and a minor axis extending in the fourth direction DR4, and may be symmetrical about the major axis and asymmetrical about the minor axis. In one or more embodiments, the first-6 emission area EA1-6 may have an asymmetric elliptical shape having a greater length in the sixth direction DR6 than in a direction opposite to the sixth direction DR6 with respect to the minor axis. In one or more embodiments, the first-6 emission area EA1-6 may have a shape obtained by rotating the first-5 emission area EA1-5 about 30 degrees in the clockwise direction.

In one or more embodiments, the first-7 emission area EA1-7 may have a major axis extending in the x direction and a minor axis extending in the y direction, and may be symmetrical about the major axis and asymmetrical about the minor axis. In one or more embodiments, the first-7 emission area EA1-7 may have an asymmetric elliptical shape having a smaller length in the -x direction than in the +x direction with respect to the minor axis. In one or more embodiments, the first-7 emission area EA1-7 may have a shape obtained by rotating the first-6 emission area EA1-6 about 30 degrees in the clockwise direction. In one or more embodiments, the first-7 emission area EA1-7 may be a mirror image of the first-1 emission area EA1-1 with respect to the y direction.

In one or more embodiments, the first-8 emission area EA1-8 may have a major axis extending in the third direction DR3 and a minor axis extending in the fifth direction DR5, and may be symmetrical about the major axis and asymmetrical about the minor axis. In one or more embodiments, the first-8 emission area EA1-8 may have an asymmetric elliptical shape having a smaller length in the third direction DR3 than in a direction opposite to the third direction DR3 with respect to the minor axis. In one or more embodiments, the first-8 emission area EA1-8 may have a shape obtained by rotating the first-7 emission area EA1-7 about 30 degrees in the clockwise direction. In one or more embodiments, the first-8 emission area EA1-8 may be a mirror image of the first-2 emission area EA1-2 with respect to the fifth direction DR5.

In one or more embodiments, the first-9 emission area EA1-9 may have a major axis extending in the fourth direction DR4 and a minor axis extending in the sixth direction DR6, and may be symmetrical about the major axis and asymmetrical about the minor axis. In one or more embodiments, the first-9 emission area EA1-9 may have an asymmetric elliptical shape having a smaller length in the fourth direction DR4 than in a direction opposite to the fourth direction DR4 with respect to the minor axis. In one or more embodiments, the first-9 emission area EA1-9 may have a shape obtained by rotating the first-8 emission area EA1-8 about 30 degrees in the clockwise direction. In one or more embodiments, the first-9 emission area EA1-9 may be a mirror image of the first-3 emission area EA1-3 with respect to the sixth direction DR6.

In one or more embodiments, the first-10 emission area EA1-10 may have a major axis extending in the y direction and a minor axis extending in the x direction, and may be symmetrical about the major axis and asymmetrical about the minor axis. In one or more embodiments, the first-10 emission area EA1-10 may have an asymmetric elliptical shape having a smaller length in the +y direction than in the -y direction with respect to the minor axis. In one or more embodiments, the first-10 emission area EA1-10 may have a shape obtained by rotating the first-9 emission area EA1-9 about 30 degrees in the clockwise direction. In one or more embodiments, the first-10 emission area EA1-10 may be a mirror image of the first-4 emission area EA1-4 with respect to the x direction.

In one or more embodiments, the first-11 emission area EA1-11 may have a major axis extending in the fifth direction DR5 and a minor axis extending in the third direction DR3, and may be symmetrical about the major axis and asymmetrical about the minor axis. In one or more embodiments, the first-11 emission area EA1-11 may have an asymmetric elliptical shape having a smaller length in the fifth direction DR5 than in a direction opposite to the fifth direction DR5 with respect to the minor axis. In one or more embodiments, the first-11 emission area EA1-11 may have a shape obtained by rotating the first-10 emission area EA1-10 about 30 degrees in the clockwise direction. In one or more embodiments, the first-11 emission area EA1-11 may be a mirror image of the first-5 emission area EA1-5 with respect to the third direction DR3.

In one or more embodiments, the first-12 emission area EA1-12 may have a major axis extending in the sixth direction DR6 and a minor axis extending in the fourth direction DR4, and may be symmetrical about the major axis and asymmetrical about the minor axis. In one or more embodiments, the first-12 emission area EA1-12 may have an asymmetric elliptical shape having a smaller length in the sixth direction DR6 than in a direction opposite to the sixth direction DR6 with respect to the minor axis. In one or more embodiments, the first-12 emission area EA1-12 may have a shape obtained by rotating the first-11 emission area EA1-11 about 30 degrees in the clockwise direction. In one or more embodiments, the first-12 emission area EA1-12 may be a mirror image of the first-6 emission area EA1-6 with respect to the fourth direction DR4.

Hereinafter, referring to FIGS. 16A to 16D, the first shape SH1 and the second shape SH2 may be obtained by overlapping the first-1 to first-12 emission areas EA1-1, EA1-2, EA1-3, EA1-4, EA1-5, EA1-6, EA1-7, EA1-8, EA1-9, EA1-10, EA1-11, and EA1-12 with one another. In one or more embodiments, the first shape SH1 may be obtained by overlapping the first-1 to first-12 emission areas EA1-1, EA1-2, EA1-3, EA1-4, EA1-5, EA1-6, EA1-7, EA1-8, EA1-9, EA1-10, EA1-11, and EA1-12 with one another.

In one or more embodiments, as shown in FIG. 16B, the first shape SH1 may be obtained by drawing an outermost line of a shape obtained by overlapping the first-1 to first-12 emission areas EA1-1, EA1-2, EA1-3, EA1-4, EA1-5, EA1-6, EA1-7, EA1-8, EA1-9, EA1-10, EA1-11, and EA1-12 with one another, for example, an atomic model shape. In one or more embodiments, the first shape SH1 may be obtained by connecting portions of respective outlines of the first-1 to first-12 emission areas EA1-1, EA1-2, EA1-3, EA1-4, EA1-5, EA1-6, EA1-7, EA1-8, EA1-9, EA1-10, EA1-11, and EA1-12 to one another.

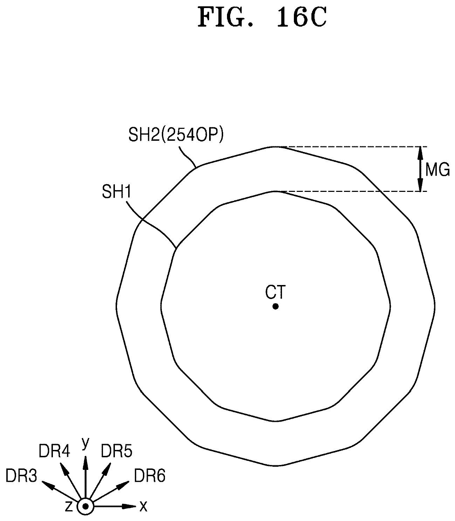

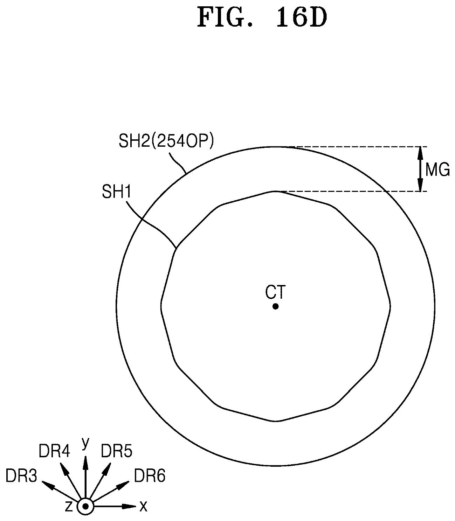

In one or more embodiments, as shown in FIGS. 16C and 16D, the first shape SH1 may be obtained by overlapping the first-1 to first-12 emission areas EA1-1, EA1-2, EA1-3, EA1-4, EA1-5, EA1-6, EA1-7, EA1-8, EA1-9, EA1-10, EA1-11, and EA1-12 with one another, and then arranging a tangent between each of adjacent first emission areas EA1 and drawing an outermost line. Accordingly, the first shape SH1 in FIGS. 16C and 16D may be a dodecagon with approximately rounded corners.

The size of the second shape SH2 corresponding to the first shape SH1 may be greater than the size of the first shape SH1.

In one or more embodiments, as shown in FIGS. 16B and 16C, the second shape SH2 may be geometrically the same as the first shape SH1 and may have larger dimensions than the first shape SH1. For example, the second shape SH2 may be geometrically the same as the first shape SH1, but may be expanded by the process margin MG in all directions.

In one or more embodiments, as shown in FIG. 16D, the second shape SH2 may be geometrically different from the first shape SH1 and may have larger dimensions than the first shape SH1. For example, the second shape SH2 may be a circle or an ellipse, each expanded by the process margin MG from an outermost edge of the first shape SH1. In this regard, the outermost edge of the first shape SH1 may refer to, for example, rounded corners of the first shape SH1.

In one or more embodiments, if (e.g., when) a sufficient number of the first emission areas EA1 are provided, the first shape SH1 may be a shape close to a curved body (for example, a circle or an ellipse) with substantially no concave portion. For example, if (e.g., when) the number of the first emission areas EA1 has been achieved or beyond a threshold, such a number of the first emission areas EA1 may render the first shape SH1 to be nearly a circle shape or an ellipse shape, as in an angle formed by the major axes of any two adjacent first emission areas (e.g., the first-1 emission area EA1-1 and the first-2 emission area EA1-2) is small enough to form a nearly (e.g., almost) curvy edge at both (e.g., opposite) ends on the major/longitudinal axes of the two adjacent first emission areas. Even in this case, the second shape SH2 may be geometrically the same as the first shape SH1 or may be geometrically different from the first shape SH1. In either case, the second shape SH2 may secure the process margin MG with respect to the first shape SH1.

In one or more embodiments, referring to FIGS. 12 and 13 in conjunction with FIGS. 16A to 16D, if (e.g., when) a deposition process is performed on the display substrate DS by utilizing the deposition mask 25 including the tension sheet 254 having the opening 254OP having the second shape SH2, an edge of the opening 254OP in the tension sheet 254 may be spaced and/or apart (e.g., spaced apart or separated) from an edge (or an outline) of the corresponding emission area EA if (e.g., when) viewed in a deposition direction (for example, the z direction).

By implementing the opening 254OP having the second shape SH2 as described above, the process margin MG for deposition errors of a deposition material that has passed through the tension sheet 254 of the deposition mask 25 may be secured for all emission areas. For example, referring to FIGS. 8B and 14D in conjunction with FIGS. 16A to 16D, by utilizing the opening 254OP that is larger by the process margin MG than the x-directional edge, which is an outermost edge, of the first-1 emission area EA1-1, it may be ensured that the first-1 deposition pattern 114a1 fully covers the first-1 emission area EA1-1. Such coverage may similarly be ensured for the first-2 emission area EA1-2 and the first-2 deposition pattern 114a2, the first-3 emission area EA1-3 and the first-3 deposition pattern 114a3, and the first-4 emission area EA1-4 and the first-4 deposition pattern 114a4. At the same time, instead of providing, in the tension sheet 254, the openings 254OP, for example, openings having different shapes from one another, corresponding to the first-1 to first-4 emission areas EA1-1, EA1-2, EA1-3, and EA1-4 respectively, the openings 254OP having a single shape, for example, the second shape SH2, may be provided in the tension sheet 254. This may facilitate the design and manufacturing of the tension sheet 254 and the deposition mask 25 and further reduce errors occurring in a deposition process.

For example, when a sufficient number of first emission areas EA1 are provided, the first shape SH1 may resemble a curved body, such as a circle or ellipse, with no concave portions. This shape is achieved by overlapping the emission areas, forming nearly curvy edges. The second shape SH2, used in the deposition mask, may be geometrically similar or different from the first shape SH1 but ensures the process margin MG is secured. During the deposition process, the opening 254OP in the tension sheet 254, having the second shape SH2, is spaced apart from the edge of the emission area EA when viewed in the deposition direction. This design secures the process margin for deposition errors and ensures full coverage of the emission areas by the deposition patterns. Using a single shape for the openings in the tension sheet facilitates design and manufacturing, reducing errors in the deposition process.

Hereinbefore, a method of designing the second shape SH2 and the tension sheet 254 including the openings 254OP having a single shape (for example, the second shape SH2) that may cover one or more suitable emission areas has been described. The disclosure is not necessarily limited to the arrangement of the emission areas EA described with reference to FIGS. 8A to 11B. In addition, the disclosure is not necessarily limited to the shape (for example, an ellipse shape) of the emission areas EA described with reference to FIGS. 14A to 16D.

In one or more embodiments, a display panel manufacturing apparatus including a deposition mask, a method for manufacturing a display panel by performing a deposition process utilizing a deposition mask, a display panel manufactured utilizing such a manufacturing apparatus and/or a manufacturing method, and an electronic apparatus including such a display panel may be provided.

The display panel may include emission areas having one or more suitable shapes. The deposition mask does not have openings having shapes respectively corresponding to the one or more suitable shapes of the emission areas of the display panel, but rather may have openings having a single shape that may cover all the one or more suitable shapes of the emission areas.

Because openings formed in the deposition mask may have a single shape instead of individual shapes corresponding to the emission areas respectively, the production time and production cost of the deposition mask may be reduced. In addition, because the deposition mask includes openings that may cover all of the one or more suitable shapes of the emission areas, a process margin may be secured in a deposition process, and the occurrence of misplaced deposition of a deposition material may be reduced.

In the context of the present disclosure and unless otherwise defined, the terms "use/utilize," "using/utilizing," and "used/utilized" may be considered synonymous with the terms "utilize," "utilizing," and "utilized," respectively.

A person of ordinary skill in the art would appreciate, in view of the present disclosure in its entirety, that each suitable feature of the one or more suitable embodiments of the present disclosure may be combined or combined with each other (or one another), partially or entirely, and may be technically interlocked and operated in one or more suitable ways, and each embodiment may be implemented independently of each other (or one another) or in conjunction with each other (or one another) in any suitable manner unless otherwise stated or implied.

The display apparatus/device, the electronic apparatus/device, the manufacturing apparatuses thereof, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In concluding the detailed description, those skilled in the art will appreciate that many variations and modifications may be made to one or more embodiments of the present application without substantially departing from the principles of disclosure. Therefore, the disclosed embodiments of present disclosure are utilized in a generic and descriptive sense only and not for purposes of limitation.

It should be understood that embodiments described herein should be considered in a descriptive sense only and not for purposes of limitation. Descriptions of features or aspects within each embodiment should typically be considered as available for other similar features or aspects in one or more embodiments. While one or more embodiments have been described with reference to the drawings, it will be understood by those of ordinary skill in the art that one or more suitable changes in form and details may be made therein without departing from the scope as defined by the appended claims and equivalents thereof. Moreover, it shall be appreciated that the one or more embodiments of the present disclosure are not intended to restrict the present disclosure thereto and that every technical idea within the scope of the appended claims and their equivalents is interpreted to be included in the scope of the present disclosure and equivalents thereof.

## Claims

1. An apparatus (20) for manufacturing a display panel (11) including a plurality of emission areas (EA), the apparatus (20) comprising:
a deposition source (24); and
a deposition mask (25) comprising a plurality of openings (254OP) corresponding to the plurality of emission areas (EA) of the display panel (11),
wherein at least some of the plurality of openings (254OP) in the deposition mask (25) have a second shape (SH2) corresponding to a first shape (SH1) obtained by overlapping the plurality of emission areas (EA) with one another.

2. The apparatus (20) of claim 1, wherein the first shape (SH1) is obtained by:
connecting at least some of outermost portions of the plurality of emission areas (EA) that overlap one another; and or
aligning centers of the plurality of emission areas (EA) and overlapping the plurality of emission areas (EA).

3. The apparatus (20) of claim 1 or 2, wherein:
a shape of at least one emission area (EA) selected from among the plurality of emission areas (EA) is different from a shape of another emission area (EA) selected from among the plurality of emission areas (EA); and/or
shapes of the plurality of openings (254OP) in the deposition mask (25) are same as one another; and/or
the first shape (SH1) and the second shape (SH2) are geometrically same as one another.

4. The apparatus (20) of any one of the preceding claims, wherein a size or dimensions of the second shape (SH2) is greater than a size or dimensions of the first shape (SH1).

5. The apparatus (20) of any one of the preceding claims, wherein, in plan view, an edge of each of the plurality of openings (254OP) in the deposition mask (25) is spaced or apart from an outline of each of the plurality of emission areas (EA).

6. The apparatus (20) of any one of the preceding claims, wherein the plurality of emission areas (EA) comprise elliptical areas having major axes extending in different directions from one another.

7. A method for manufacturing a display panel (11), the method comprising:
arranging, on a substrate (100, DS), a pixel-defining layer (112) comprising a plurality of emission areas (EA);
arranging, on the pixel-defining layer (112), a deposition mask (25) comprising a plurality of openings (254OP) corresponding to the plurality of emission areas (EA); and
spraying a deposition material toward the deposition mask (25) and the pixel-defining layer (112),
wherein at least some of the plurality of openings (254OP) in the deposition mask (25) have a second shape (SH2) corresponding to a first shape (SH1) obtained by overlapping the plurality of emission areas (EA).

8. The method of claim 7, wherein the first shape (SH1) is obtained by:
connecting at least some of outermost portions of the plurality of emission areas (EA) that overlap one another; and/or
aligning centers of the plurality of emission areas (EA) and overlapping the plurality of emission areas (EA).

9. The method of claim 7 or 8, wherein:
a shape of at least one emission area selected from among the plurality of emission areas (EA) is different from a shape of another emission area (EA) selected from among the plurality of emission areas (EA); and/or
shapes of the plurality of openings (254OP) in the deposition mask (25) are same as one another; and/or
the first shape (SH1) and the second shape (SH2) are geometrically same as one another.

10. The method of any one of claims 7 to 9, wherein a size or dimensions of the second shape (SH2) is greater than a size or dimensions of the first shape (SH1).

11. The method of any one of claims 7 to 10, wherein the pixel-defining layer (112) comprises a plurality of holes (H) defining the plurality of emission areas (EA).

12. The method of claim 11, wherein an edge of each of the plurality of openings (254OP) in the deposition mask (25) is spaced from an edge of each of the plurality of holes (H) in the pixel-defining layer (112) in a direction in which the deposition material spray.

13. The method of any one of claims 7 to12, wherein the plurality of emission areas (EA) comprise elliptical areas having major axes extending in different directions from one another.

14. An electronic apparatus (10) comprising a display panel (11) comprising a plurality of emission areas (EA), wherein the display panel (11) comprises:
a substrate (100, DS);
a plurality of pixel electrodes (113) on the substrate (100, DS);
a pixel-defining layer (112) on the plurality of pixel electrodes (113) and comprising a plurality of holes (H) defining the plurality of emission areas (EA);
an intermediate layer (114) overlapping the plurality of holes (H) on the pixel-defining layer (112), and comprising a plurality of deposition patterns (DPT), each of the plurality of deposition patterns (DPT) having a portion arranged within a corresponding hole (H) among the plurality of holes (H); and
an opposite electrode (115) on the intermediate layer (114),
wherein, in plan view, at least some of the plurality of deposition patterns (DPT) have a second shape (SH2) corresponding to a first shape (SH1) obtained by overlapping the plurality of holes (H).

15. The electronic device of claims 14, wherein one deposition pattern (DPT) among the plurality of deposition patterns (DPT) has a first portion at the corresponding hole (H) of the pixel-defining layer (112) and a second portion on a top surface of the pixel-defining layer (112), and
the first portion of the deposition pattern (DPT) is connected to the second portion of the deposition pattern (DPT).
